# EUROPEAN PATENT APPLICATION

(11) **EP 4 776 787 A1**
(43) Date of publication of application: **15.07.2026**
(21) Application number: 25194794.1
(22) Date of filing: 08.08.2025
(51) Int. Cl.: H10D 30/47, H10D 30/01, H10D 64/23, H10D 62/17, H10D 62/13, H10D 64/20, H10D 64/27, H10D 62/85

(54) **SEMICONDUCTOR DEVICE**

(30) Priority: 13.01.2025 KR 20250005068
(71) Applicant: SAMSUNG ELECTRONICS CO., LTD., Yeongtong-gu Suwon-si, Gyeonggi-do 16677 (KR)
(72) Inventor: KIM, Joonyong, 16677 Suwon-si, Gyeonggi-do (KR); KIM, Sanghyun, 16677 Suwon-si, Gyeonggi-do (KR); KIM, Jongseob, 16677 Suwon-si, Gyeonggi-do (KR); PARK, Junhyuk, 16677 Suwon-si, Gyeonggi-do (KR); YANG, Seong Seok, 16677 Suwon-si, Gyeonggi-do (KR); OH, Jaejoon, 16677 Suwon-si, Gyeonggi-do (KR)
(74) Representative: Kuhnen & Wacker Patent- und Rechtsanwaltsbüro PartG mbB

(57) **Abstract**

A semiconductor device includes a channel layer (132), a barrier layer (136) on the channel layer (132), a gate electrode layer (155) on the barrier layer (136) and extending in a first direction (D1) parallel to an upper surface of the barrier layer (136), a gate semiconductor layer (152) between the barrier layer (136) and the gate electrode layer (155), a source electrode (173) and a drain electrode (175) connected to the channel layer (132) and spaced apart from the gate electrode layer (155) in a second direction (D2) parallel to the upper surface of the barrier layer (136) and different from the first direction (D1), and a first barrier layer doping region (1361) within the barrier layer (136) and connected to the source electrode (173). In a cross-section in the second direction (D2) and in a third direction (D3) perpendicular to the upper surface of the barrier layer (136), an upper surface length of the gate electrode layer (155) is less than a lower surface length of the gate electrode layer (155).

## Description

### BACKGROUND

In modern society, semiconductor devices are closely related to daily life. In particular, the importance of power semiconductor devices used in various fields such as transportation fields such as electric vehicles, railroads, and electric trams, renewable energy systems such as solar power generation and wind power generation, and mobile devices is gradually increasing. Power semiconductor devices may be semiconductor devices used to handle high voltage or high current, and may perform functions such as power conversion and control in large power systems or high-output electronic devices. Power semiconductor devices may have the ability and durability to handle high power, and may handle large amounts of current and withstand high voltage. For example, power semiconductor devices may handle voltages from hundreds of volts to thousands of volts and currents from tens of amperes to thousands of amperes. Power semiconductor devices may enhance the efficiency of electrical energy by minimizing power loss. Additionally, power semiconductor devices may be stably operated even in environments such as high temperatures.

### SUMMARY

One aspect of the present disclosure is to provide a semiconductor device that can improve an ohmic contact between a source electrode and a channel layer, thereby reducing contact resistance, while also improving the alignment between a gate electrode layer and a gate semiconductor layer.

A semiconductor device according to an aspect includes a channel layer, a barrier layer located on the channel layer, a gate electrode layer located on the barrier layer and extending in a first direction parallel to an upper surface of the barrier layer, a gate semiconductor layer located between the barrier layer and the gate electrode layer, and a source electrode and a drain electrode connected to the channel layer and spaced apart from the gate electrode layer in a second direction parallel to the upper surface of the barrier layer and different from the first direction, where the semiconductor device further includes a first barrier layer doping region located within the barrier layer and connected to the source electrode, and wherein, in a cross-section cut in the second direction and in a third direction perpendicular to the upper surface of the barrier layer, a length of an upper surface of the gate electrode layer in the second direction is less than a length of a lower surface of the gate electrode layer in the second direction.

A semiconductor device according to another aspect includes a channel layer, a barrier layer located on the channel layer, a gate electrode layer located on the barrier layer and extending in a first direction parallel to an upper surface of the barrier layer, a gate semiconductor layer located between the barrier layer and the gate electrode layer, and a source electrode and a drain electrode connected to the channel layer and spaced apart from the gate electrode layer in a second direction parallel to the upper surface of the barrier layer and different from the first direction, where the semiconductor device further includes a first barrier layer doping region located within the barrier layer and connected to the source electrode, wherein the source electrode has a first portion located on the first barrier layer doping region and a second portion protruding from the first portion toward the first barrier layer doping region and located within the first barrier layer doping region, and wherein, in a cross-section cut in the second direction and in a third direction perpendicular to the upper surface of the barrier layer, a length of an upper surface of the second portion in the second direction is greater than a length of a lower surface of the second portion in the second direction.

A semiconductor device according to another aspect includes a channel layer, a barrier layer located on the channel layer, a gate electrode layer located on the barrier layer and extending in a first direction parallel to an upper surface of the barrier layer, a gate semiconductor layer located between the barrier layer and the gate electrode layer, and a source electrode and a drain electrode connected to the channel layer and spaced apart from the gate electrode layer in a second direction parallel to the upper surface of the barrier layer and different from the first direction, where the semiconductor device further includes a first barrier layer doping region located within the barrier layer and connected to the source electrode, where the source electrode has a first portion located on the first barrier layer doping region and a second portion protruding from the first portion toward the first barrier layer doping region and located within the first barrier layer doping region, and where, in a cross-section cut in the second direction and in a third direction perpendicular to the upper surface of the barrier layer, a length of an upper surface of the second portion in the second direction is greater than a length of a lower surface of the second portion in the second direction, and a length of an upper surface of the gate electrode layer in the second direction is less than a length of the gate electrode layer in the second direction.

A manufacturing method of a semiconductor device according to one aspect includes forming a channel layer on a substrate, forming a barrier layer on the channel layer, forming a gate semiconductor material layer on the barrier layer, ion-doping a part of the barrier layer to form a first barrier layer doping region, forming a gate electrode material layer on the gate semiconductor material layer, etching the gate electrode material layer to form a gate electrode layer, etching the gate semiconductor material layer to form a gate semiconductor layer, and forming a source electrode connected to the first barrier layer doping region and spaced apart from the gate electrode layer.

In some examples, when the ion-doping is performed on a part of the barrier layer to form the first barrier layer doping region, the ion-doping may be also performed on the gate semiconductor material layer to form a first gate semiconductor material layer doping region, and the ion-doping may be also performed on the channel layer to form a first channel layer doping region.

In some implementations, forming the first barrier layer doping region may include, forming a first photoresist pattern on the gate semiconductor material layer, ion-doping a portion of the barrier layer using the first photoresist pattern by ion-implantation (IIP) method, and annealing at 1100 °C to 2000 °C.

In some implementations, after forming the first barrier layer doping region, the first gate semiconductor material layer doping region may be etched and removed using a first photoresist pattern, exposing the first barrier layer doping region, and a part of a surface of the first barrier layer doping region may be etched to form a first recess on the surface of the first barrier layer doping region.

In some implementations, forming the first barrier layer doping region may include forming a first photoresist pattern on a gate semiconductor material layer, etching a part of the gate semiconductor material layer using a first photoresist pattern to expose a part of the barrier layer, etching a part of a surface of the barrier layer to form a first recess on the surface of the barrier layer, performing ion-doping on a part of the barrier layer using an ion-implantation (IIP) method using the first photoresist pattern, and annealing at 1100 °C to 2000 °C.

In some implementations, forming the first barrier layer doping region may include forming a first hard mask material layer on a gate semiconductor material layer, forming a first photoresist pattern on the first hard mask material layer, etching the first hard mask material layer using the first photoresist pattern to form a first hard mask layer, etching a part of the gate semiconductor material layer using the first hard mask layer to expose a part of the barrier layer, etching a part of a surface of the barrier layer to form a first recess on the surface of the barrier layer, performing ion-doping on a part of the barrier layer using an ion-implantation (IIP) method, and annealing at 1100 °C to 2000 °C.

In some implementations, forming the source electrode may include forming a first protective layer covering a barrier layer, a gate semiconductor layer, a gate electrode layer, and a first rear doping region, etching a part of the first protective layer to expose a first barrier layer doping region, and forming a source electrode on the first barrier layer doping region.

In some implementations, forming the source electrode may include forming a first protective layer covering a barrier layer, a gate semiconductor layer, a gate electrode layer, and a first rear doping region, etching a part of the first protective layer to expose a first barrier layer doping region and a first channel layer doping region, etching a part of a surface of the first channel layer doping region to form a second recess on the surface of the first channel layer doping region, and forming the source electrode on the first channel doping region.

In some examples, when the ion-doping is performed on a part of the barrier layer to form a first barrier layer doping region, the ion-doping may be performed on another part of the barrier layer to further form a second barrier layer doping region, and the ion-doping may be performed on another part of the channel layer to further form a second channel layer doping region. When forming the source electrode, a drain electrode may further be formed so as to be connected to the second barrier layer doping region and spaced apart from the gate electrode layer and the source electrode.

In some implementations, forming the gate electrode layer may include forming a second hard mask material layer on a gate electrode material layer, forming a second photoresist pattern on the second hard mask material layer, and etching the second hard mask material layer and the gate electrode material layer using the second photoresist pattern to form a second hard mask layer and a gate electrode layer.

In some implementations, forming the gate semiconductor layer may include removing the second photoresist pattern and etching the gate semiconductor material layer using a second hard mask layer to form the gate semiconductor layer.

The semiconductor device according to the present disclosure can improve an ohmic contact between the source electrode and the channel layer, thereby reducing contact resistance, while also improving the alignment between the gate electrode layer and the gate semiconductor layer.

For example, an angle defined by a side surface of the second portion of the source electrode in the second direction and an upper surface of the first barrier layer doping region is different from an angle defined by a side surface of the third portion of the source electrode in the second direction and the upper surface of the first channel layer doping region. For example, the drain electrode comprises a first portion on the first barrier layer doping region. For example, the drain electrode comprises a second portion protruding from the first portion toward the second barrier layer doping region, the second portion being within the second barrier layer doping region. For example, the drain electrode comprises a third portion protruding from the second portion toward the second channel layer doping region. For example, the third portion being within the second channel layer doping region. For example, the semiconductor device comprises a first protective layer on (i) the barrier layer and (ii) the first barrier layer doping region. For example, the first protective layer covers the gate electrode layer. For example, the source electrode extends into the first protective layer. For example, the source electrode is connected to the first barrier layer doping region.

### BRIEF DESCRIPTION OF THE DRAWINGS

FIG. 1 is a top plan view showing an example of a semiconductor device.
FIG. 2 is a cross-sectional view taken along line A-A' of FIG. 1.
FIG. 3 is an enlarged cross-sectional view of an example of a portion P of FIG. 2.
FIG. 4 is an enlarged cross-sectional view of an example of a portion Q of FIG. 2.
FIG. 5 is an enlarged cross-sectional view of an example of a portion P of FIG. 2.
FIG. 6 is an enlarged cross-sectional view of an example of portion P of FIG. 2.
FIG. 7 is an enlarged cross-sectional view of an example of portion P of FIG. 2.
FIG. 8 is an enlarged cross-sectional view of an example of portion P of FIG. 2.
FIG. 9 is a cross-sectional view taken along line A-A' of FIG. 1 according to some examples.
FIG. 10 is an enlarged cross-sectional view of an example of portion Q of FIG. 9. FIG. 11 is a cross-sectional view taken along line A-A' of FIG. 1 according to some examples.
FIG. 12 is an enlarged cross-sectional view of an example of portion Q of FIG. 11.
FIG. 13 is an enlarged cross-sectional view of an example of portion Q of FIG. 11.
FIG. 14 is a cross-sectional view taken along line A-A' of FIG. 1 according to some examples.
FIG. 15 is an enlarged cross-sectional view of an example of portion Q of FIG. 14.
FIG. 16 is an enlarged cross-sectional view of an example of portion Q of FIG. 14.
FIG. 17 is a cross-sectional view taken along line A-A' of FIG. 1, according to some examples.
FIG. 18 is an enlarged cross-sectional view of an example of portion Q of FIG. 17.
FIG. 19 is an enlarged cross-sectional view of an example of portion Q of FIG. 17.
FIG. 20 is an enlarged cross-sectional view of an example of portion Q of FIG. 17.
FIG. 21 is an enlarged cross-sectional view of an example of portion Q of FIG. 17.
FIG. 22 is an enlarged cross-sectional view of an example of portion Q of FIG. 17.
FIG. 23 is an enlarged cross-sectional view of an example of portion Q of FIG. 17.
FIGS. 24 to 32 are cross-sectional views showing a method for manufacturing an example of a semiconductor device.
FIGS. 33 to 40 are cross-sectional views showing a method for manufacturing an example of a semiconductor device.

### DETAILED DESCRIPTION

Hereinafter, various implementations of the present disclosure will be described in detail with reference to the attached drawings so that a person having ordinary skill in the art to which the present disclosure pertains can easily implement the present disclosure. The present disclosure may be embodied in many different froms and is not limited to the implementations set forth herein.

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" means being disposed on or below the object portion, and does not necessarily mean being disposed on the upper side of the object portion based on a gravitational direction.

The word "offset" can refer to a positional relationship in which a first component is positioned such that at least a portion of the first component is laterally or vertically displaced from a second component. The word "offset" can include configurations where the first component is in direct contact with the second component (e.g., side-to-side, edge-to-edge, or partially overlapping), regardless of whether the components are fully aligned, partially aligned, or misaligned.

In addition, in this specification, the phrase "on a plane" means viewing a target portion from the top, and the phrase "on a cross-section" means viewing a cross-section formed by vertically cutting a target portion from the side.

Additionally, throughout the specification, two directions parallel to an upper surface of a substrate and intersecting each other are defined as a first direction D1 and a second direction D2, respectively, and a direction perpendicular to the upper surface of the substrate is defined as a third direction D3.

For example, the first direction D1 and the second direction D2 may be perpendicular to each other.

Power semiconductor devices may be classified according to materials, and examples include silicon carbide (SiC) power semiconductor devices and gallium nitride (GaN) power semiconductor devices. Power semiconductor devices may be manufactured using SiC or GaN instead of existing silicon wafer (Si wafer), and thereby the disadvantage of silicon, which has unstable characteristics at high temperatures, may be compensated. The SiC power semiconductor devices may be resistant to high temperatures and have low power loss, and may be suitable for electric vehicles, renewable energy systems, etc. The GaN power semiconductor devices may result require high costs, but may be efficient in terms of speed and may be suitable for high-speed charging of mobile devices.

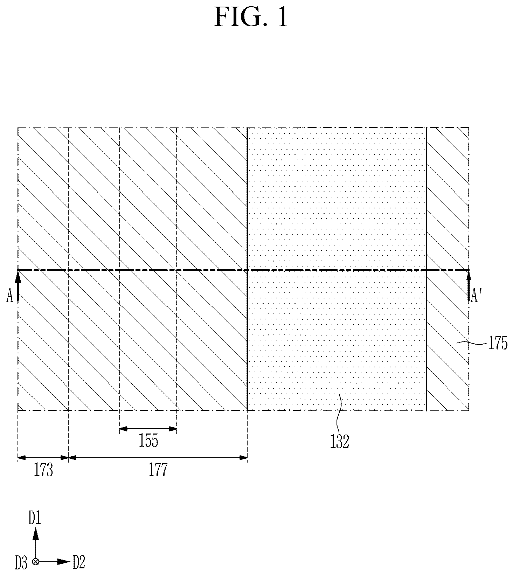

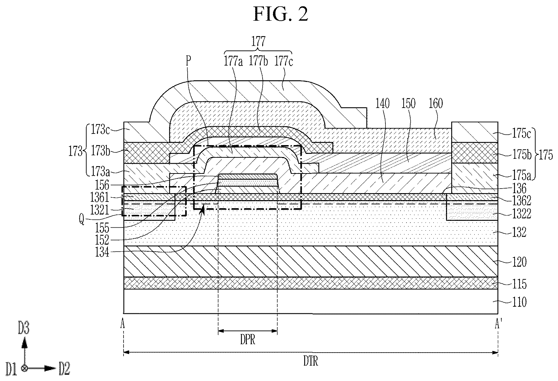

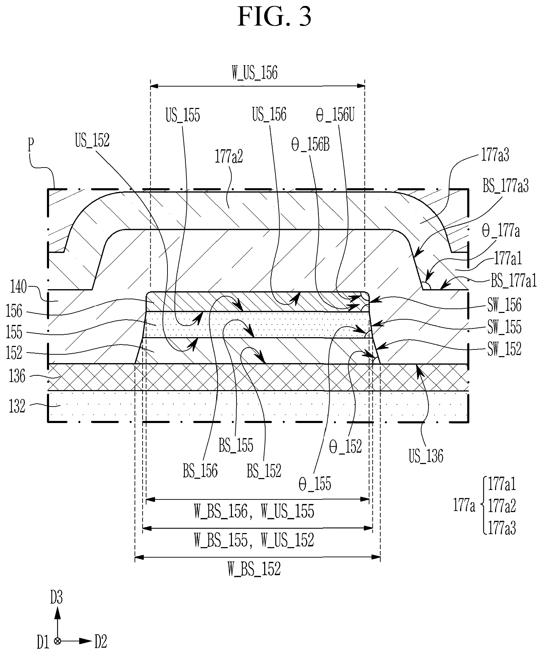

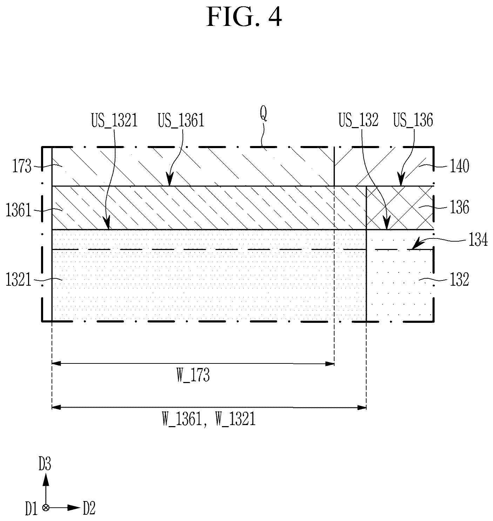

FIG. 1 is a top plan view showing a semiconductor device according to an implementation. FIG. 2 is a cross-sectional view taken along line A-A' of FIG. 1. FIG. 3 is an enlarged cross-sectional view of portion P of FIG. 2. FIG. 4 is an enlarged cross-sectional view of portion Q of FIG. 2.

For clear understanding and simple illustration, FIG. 1 mainly depicts a channel layer 132, a gate electrode layer 155, a source electrode 173, a field dispersion layer 177, and a drain electrode 175.

Referring to FIGS. 1 to 4, the semiconductor device includes a channel layer 132, a barrier layer 136 located on the channel layer 132, a gate electrode layer 155 located on the barrier layer 136, a gate semiconductor layer 152 located between the barrier layer 136 and the gate electrode layer 155, and a source electrode 173 and a drain electrode 175 located on both sides of the gate electrode layer 155 and connected to the channel layer 132.

The channel layer 132 may be a layer that forms a channel between the source electrode 173 and the drain electrode 175, and a two-dimensional electron gas (2DEG) 134 may be located inside the channel layer 132. The two-dimensional electron gas 134 may refer to a group of electrons that can move freely in two dimensions (e.g., in D1-D2 plane direction) as a charge transport model used in solid physics but cannot move and are tightly bound in another dimension (e.g., in D3 direction). In other words, the two-dimensional electron gas 134 may exist in a two-dimensional paper-like form within a three-dimensional space. This two-dimensional electron gas 134 mainly appears in a semiconductor heterojunction structure, and may occur at the interface between the channel layer 132 and the barrier layer 136 in the semiconductor device according to an implementation. For example, the two-dimensional electron gas 134 may be generated in the portion closest to the barrier layer 136 within the channel layer 132.

The channel layer 132 may include nitride including Group III-V materials, for example, Aluminum (Al), Gallium (Ga), Indium (In), Boron (B), or a combination thereof. The channel layer 132 may be made of a single layer or multiple layers. As an example, the channel layer 132 may include AlₓIn_{y}Ga_{1-x-y}N (0≤x≤1, 0≤y≤1, x+y≤1). For example, the channel layer 132 may include AIN, GaN, InN, InGaN, AlGaN, AlInN, AlInGaN, or a combination thereof. The channel layer 132 may be a layer doped with impurities or a layer undoped with impurities. A thickness of the channel layer 132 may be about several hundred nm or less.

The channel layer 132 may be located on the substrate 110, and a seed layer 115, or a buffer layer 120 may be located between the substrate 110 and the channel layer 132. The substrate 110, the seed layer 115, and the buffer layer 120 are layers necessary to form the channel layer 132, and may be omitted in some cases. For example, when a substrate made of GaN is used as the channel layer 132, at least one of the substrate 110, the seed layer 115, and the buffer layer 120 may be omitted. Considering that the price of a substrate made of GaN is relatively high, the channel layer 132 including GaN may be grown using the substrate 110 made of Si. At this time, as the lattice structure of Si and GaN are different, it may not be easy to grow the channel layer 132 directly on the substrate 110. Accordingly, the seed layer 115 and the buffer layer 120 may be first grown on the substrate 110, and then the channel layer 132 may be grown on the buffer layer 120. Additionally, at least one of the substrate 110, the seed layer 115, and the buffer layer 120 may be removed from the final structure of the semiconductor device after being used in the manufacturing process.

A first channel layer doping region 1321 may be located within the channel layer 132. The first channel layer doping region 1321 may be located on an upper portion of the channel layer 132. In other words, a level of an upper surface US_1321 of the first channel layer doping region 1321 in the third direction D3 may be equal to a level of an upper surface US_132 of the channel layer 132 in the third direction D3, and the upper surface US_1321 of the first channel layer doping region 1321 and the upper surface US_132 of the channel layer 132 may be coplanar.

Similarly, a second channel layer doping region 1322 may be located within the channel layer 132. The second channel layer doping region 1322 may be located on an upper portion of the channel layer 132. In other words, a level of an upper surface of the second channel layer doping region 1322 in the third direction D3 may be equal to the level of the upper surface of the channel layer 132 in the third direction D3, and the upper surface of the second channel layer doping region 1322 and the upper surface of the channel layer 132 may be coplanar.

The first channel layer doping region 1321 may extend from the upper surface US_132 of the channel layer 132 in the lower surface direction of the channel layer 132. That is, the first channel layer doping region 1321 may extend below from the upper surface US_132 of the channel layer 132 in the third direction D3. However, a lower surface of the first channel layer doping region 1321 may extend below in the third direction D3, but does not penetrate the channel layer 132, and the lower surface of the first channel layer doping region 1321 may be located within the channel layer 132. In other words, a level of the lower surface of the first channel layer doping region 1321 in the third direction D3 may be higher than a level of the lower surface of the channel layer 132 in the third direction D3.

Similarly, the second channel layer doping region 1322 may extend from the upper surface of the channel layer 132 in the lower surface direction of the channel layer 132. That is, the second channel layer doping region 1322 may extend below from the upper surface of the channel layer 132 in the third direction D3. However, a lower surface of the second channel layer doping region 1322 may extend below in the third direction D3, but does not penetrate the channel layer 132, and the lower surface of the second channel layer doping region 1322 may be located within the channel layer 132. In other words, a level of the lower surface of the second channel layer doping region 1322 in the third direction D3 may be higher than the level of the lower surface of the channel layer 132 in the third direction D3.

Here, the level of the upper surface US_1321 of the first channel layer doping region 1321 in the third direction D3 may be, for example, the shortest distance in the third direction D3 from an upper surface of the substrate 110 to the upper surface US_1321 of the first channel layer doping region 1321. Similarly, the level of the lower surface of the first channel layer doping region 1321 in the third direction D3, the level of the upper surface of the second channel layer doping region 1322 in the third direction D3, the level of the lower surface of the second channel layer doping region 1322 in the third direction D3, the level of the upper surface US_132 of the channel layer 132 in the third direction D3, and the level of the lower surface of the channel layer 132 in the third direction D3 may be the shortest distances from the upper surface of the substrate 110 in the third direction D3.

The first channel layer doping region 1321 may be located below the source electrode 173. In other words, at least some regions of the first channel layer doping region 1321 may overlap with the source electrode 173 in the third direction D3. On the other hand, the first channel layer doping region 1321 may not overlap with the gate electrode layer 155 and drain electrode 175 in the third direction D3.

The second channel layer doping region 1322 may be located below the drain electrode 175. In other words, at least some regions of the second channel layer doping region 1322 may overlap with the drain electrode 175 in the third direction D3. On the other hand, the second channel layer doping region 1322 may not overlap with the gate electrode layer 155 and the source electrode 173 in the third direction D3.

In other words, the first channel layer doping region 1321 and the second channel layer doping region 1322 may be spaced apart from each other in the second direction D2, and the gate electrode layer 155 and the gate semiconductor layer 152 may be located between the first channel layer doping region 1321 and the second channel layer doping region 1322. The gate electrode layer 155 and the gate semiconductor layer 152 may be spaced apart from the first channel layer doping region 1321 and the second channel layer doping region 1322 in the second direction D2.

The source electrode 173 may be electrically connected to the first channel layer doping region 1321 on a side of the gate electrode layer 155 in the second direction D2. For example, the source electrode 173 may be electrically connected to the first channel layer doping region 1321 through the first barrier layer doping region 1361 described below. The first channel layer doping region 1321 may be in ohmic contact with the source electrode 173. The contact resistance between the source electrode 173 and the channel layer 132 may be reduced by the first channel layer doping region 1321.

The drain electrode 175 may be electrically connected to the second channel layer doping region 1322 on the other side of the gate electrode layer 155 in the second direction D2. For example, the drain electrode 175 may be electrically connected to the second channel layer doping region 1322 through the second barrier layer doping region 1362 described later. The second channel layer doping region 1322 may be in ohmic contact with the drain electrode 175. The contact resistance between the drain electrode 175 and the channel layer 132 may be reduced by the second channel layer doping region 1322.

The first channel layer doping region 1321 and the second channel layer doping region 1322 may extend along the first direction D1 on a plane (e.g., FIG. 1). That is, the first channel layer doping region 1321 and the second channel layer doping region 1322 may have a rod shape that extends long along the first direction D1 on a plane. The first channel layer doping region 1321 and the second channel layer doping region 1322 may extend in directions parallel to each other. The first channel layer doping region 1321 and the second channel layer doping region 1322 may extend in a direction parallel to the gate electrode layer 155.

The first channel layer doping region 1321 and the second channel layer doping region 1322 may be formed in at least some regions of the channel layer 132 by an ion injection method, for example, an ion-implantation (IIP) method.

The first channel layer doping region 1321 and the second channel layer doping region 1322 may include the same material as the channel layer 132, for example, the first channel layer doping region 1321 and the second channel layer doping region 1322 may include a nitride including group III-V materials, for example, Al, Ga, In, B, or a combination thereof.

For example, the first channel layer doping region 1321 and the second channel layer doping region 1322 may each be doped as n-type. For example, the first channel layer doping region 1321 and the second channel layer doping region 1322 may each include AlₓIn_{y}Ga_{1-x-y}N (0≤x≤1, 0≤y≤1, x+y≤1), and may each be doped with silicon (Si) or germanium (Ge). In some implementations, the material, doping type, etc. of the first channel layer doping region 1321 and the second channel layer doping region 1322 may be changed in various ways.

The substrate 110 may include a semiconductor material. For example, the substrate 110 may include sapphire, Si, SiC, AIN, GaN, or a combination thereof. The substrate 110 may be a silicon on insulator (SOI) substrate. In some implementations, the material of the substrate 110 may include or correspond to a commonly used substrate. In some cases, the substrate 110 may include an insulating material. For example, several layers, including the channel layer 132, may be first formed on a semiconductor substrate, then the semiconductor substrate may be removed and replaced with an insulating substrate.

The seed layer 115 may be located on the substrate 110. The seed layer 115 may be located directly on the substrate 110. In some implementations, another predetermined layer may be further located between the substrate 110 and the seed layer 115. The seed layer 115 may be a layer that serves as a seed for growing the buffer layer 120 and may be made of a crystal lattice structure that serves as a seed for the buffer layer 120. For example, the seed layer 115 may include AIN.

The buffer layer 120 may be located on the seed layer 115. The buffer layer 120 may be located directly on the seed layer 115. In some examples, another predetermined layer may be further located between the seed layer 115 and the buffer layer 120. The buffer layer 120 may be located between the seed layer 115 and the channel layer 132. The buffer layer 120 may include nitride including Group III-V materials, for example, Al, Ga, In, B, or a combination thereof. The buffer layer 120 may include AlₓIn_{y}Ga_{1-x-y}N (0≤x≤1, 0≤y≤1, x+y≤1). For example, the buffer layer 120 may include AIN, GaN, InN, InGaN, AlGaN, AlInN, AlInGaN, or a combination thereof. The buffer layer 120 may be made of a single layer or multiple layers. For example, the buffer layer 120 may include a superlattice layer and a high-resistance layer.

The superlattice layer alleviates a difference in lattice constant and thermal expansion coefficient between the substrate 110 and the channel layer 132, thereby relieving tensile stress and compressive stress generated between the substrate 110 and the channel layer 132. The high-resistance layer may be used to prevent the semiconductor device according to an implementation from deteriorating by preventing leakage current from flowing through the channel layer 132. To this end, the high-resistance layer may be made of a low-conductivity material to electrically insulate the substrate 110 and the channel layer 132.

The barrier layer 136 may be located on the channel layer 132. The barrier layer 136 may be located directly on the channel layer 132. In some implementations, another predetermined layer may be further located between the channel layer 132 and the barrier layer 136. A region of the channel layer 132 that is overlapped with the barrier layer 136 may be a drift region DTR. The drift region DTR may be located between the source electrode 173 and the drain electrode 175. When a potential difference occurs between the source electrode 173 and the drain electrode 175, carriers may move in the drift region DTR. The semiconductor device may be turned on/off depending on whether a voltage is applied to the gate electrode layer 155 and the magnitude of the voltage applied to the gate electrode layer 155. When a voltage greater than the threshold voltage is applied to the gate electrode layer 155 and the semiconductor device is turned on, a channel may be created in the depletion region DPR. Accordingly, movement of the carrier may occur in the drift region DTR. If a voltage lower than the threshold voltage is applied to the gate electrode layer 155 or no voltage is applied, the channel path may be blocked in the depletion region DPR and carrier movement may not occur.

The barrier layer 136 may include nitride including Group III-V materials, for example, Al, Ga, In, B, or a combination thereof. The barrier layer 136 may include AlₓIn_{y}Ga_{1-x-y}N (0≤x≤1, 0≤y≤1, x+y≤1). For example, the barrier layer 136 may include AIN, GaN, InN, InGaN, AlGaN, AlInN, AlInGaN, or a combination thereof. The energy bandgap of the barrier layer 136 can be adjusted by a composition ratio of Al or In. The barrier layer 136 may be doped with a predetermined impurity. At this time, the impurity doped into the barrier layer 136 may be a p-type dopant that can provide holes. For example, the impurity doped into the barrier layer 136 may be magnesium (Mg). By increasing or decreasing the impurity doping concentration of the barrier layer 136, the threshold voltage, on-resistance, etc. of the semiconductor device can be adjusted.

The barrier layer 136 may include a semiconductor material having different characteristics from the channel layer 132. The barrier layer 136 may be different from the channel layer 132 in at least one of polarization characteristics, energy bandgap, and lattice constant. For example, the barrier layer 136 may include a material having a different energy bandgap than the channel layer 132. At this time, the barrier layer 136 may have a higher energy bandgap than the channel layer 132 and may have a higher electrical polarization rate than the channel layer 132. The two-dimensional electron gas 134 may be induced in the channel layer 132, which has a relatively low electrical polarization rate, by the barrier layer 136. In this regard, the barrier layer 136 may also be called a channel supply layer or a two-dimensional electron gas supply layer. The two-dimensional electron gas 134 may be formed within the portion of the channel layer 132 under the interface between the channel layer 132 and the barrier layer 136. The two-dimensional electron gas 134 may have very high electron mobility.

The first barrier layer doping region 1361 may be located within the barrier layer 136. The first barrier layer doping region 1361 may be located on an upper portion of the barrier layer 136. In other words, a level of an upper surface US_1361 of the first barrier layer doping region 1361 in the third direction D3 may be equal to a level of an upper surface US_136 of the barrier layer 136 in the third direction D3, and the upper surface US_1361 of the first barrier layer doping region 1361 and the upper surface US_136 of the barrier layer 136 may be coplanar.

Similarly, a second barrier layer doping region 1362 may be located within the barrier layer 136. The second barrier layer doping region 1362 may be located on an upper portion of the barrier layer 136. In other words, a level of an upper surface of the second barrier layer doping region 1362 in the third direction D3 may be equal to a level of an upper surface of the barrier layer 136 in the third direction D3, and the upper surface of the second barrier layer doping region 1362 and the upper surface of the barrier layer 136 may be coplanar.

The first barrier layer doping region 1361 may extend from the upper surface of the barrier layer 136 in the lower surface direction of the barrier layer 136. That is, the first barrier layer doping region 1361 may extend below from the upper surface of the barrier layer 136 in the third direction D3. However, a lower surface of the first barrier layer doping region 1361 extends below in the third direction D3, but does not penetrate the barrier layer 136, and a lower surface of the first barrier layer doping region 1361 may be located within the barrier layer 136. In other words, the level of the lower surface of the first barrier layer doping region 1361 in the third direction D3 may be higher than the level of the lower surface of the barrier layer 136 in the third direction D3.

Similarly, the second barrier layer doping region 1362 may extend below from the upper surface of the barrier layer 136 in the lower surface direction of the barrier layer 136. That is, the second barrier layer doping region 1362 may extend below from the upper surface of the barrier layer 136 in the third direction D3. However, the lower surface of the second barrier layer doping region 1362 may extend below in the third direction D3, but does not penetrate the barrier layer 136, and the lower surface of the second barrier layer doping region 1362 may be located within the barrier layer 136. In other words, the level of the lower surface of the second barrier layer doping region 1362 in the third direction D3 may be higher than the level of the lower surface of the barrier layer 136 in the third direction D3.

Here, the level in the third direction D3 of the upper surface US_1361 of the first barrier layer doping region 1361 may be, for example, the shortest distance in the third direction D3 from the upper surface of the substrate 110 to the upper surface US_1361 of the first barrier layer doping region 1361. Similarly, the level of the lower surface of the first barrier layer doping region 1361 in the third direction D3, the level of the upper surface of the second barrier layer doping region 1362 in the third direction D3, the level of the lower surface of the second barrier layer doping region 1362 in the third direction D3, the level of the upper surface US_136 of the barrier layer 136 in the third direction D3, and the level of the lower surface of the barrier layer 136 in the third direction D3 may be the shortest distances from the upper surface of the substrate 110 in the third direction D3.

The first barrier layer doping region 1361 may be located below the source electrode 173. In other words, at least some regions of the first barrier layer doping region 1361 may overlap with the source electrode 173 in the third direction D3. On the other hand, the first barrier layer doping region 1361 may not overlap with the gate electrode layer 155 and drain electrode 175 in the third direction D3.

The second barrier layer doping region 1362 may be located below the drain electrode 175. In other words, at least some regions of the second barrier layer doping region 1362 may overlap with the drain electrode 175 in the third direction D3. On the other hand, the second barrier layer doping region 1362 may not overlap with the gate electrode layer 155 and the source electrode 173 in the third direction D3.

The first barrier layer doping region 1361 and the second barrier layer doping region 1362 may be spaced apart from each other in the second direction D2, and the gate electrode layer 155 and the gate semiconductor layer 152 may be located between the first barrier layer doping region 1361 and the second barrier layer doping region 1362. The gate electrode layer 155 and the gate semiconductor layer 152 may be spaced apart from the first barrier layer doping region 1361 and the second barrier layer doping region 1362 in the second direction D2.

The source electrode 173 may be electrically connected to the first barrier layer doping region 1361 on a side of the gate electrode layer 155 in the second direction D2. The first barrier layer doping region 1361 may be in ohmic contact with the source electrode 173. The contact resistance between the source electrode 173 and the channel layer 132 may be reduced by the first barrier layer doping region 1361.

The drain electrode 175 may be electrically connected to the second barrier layer doping region 1362 on the other side of the gate electrode layer 155 in the second direction D2. The second barrier layer doping region 1362 may be in ohmic contact with the drain electrode 175. The contact resistance between the drain electrode 175 and the channel layer 132 may be reduced by the second barrier layer doping region 1362.

The first barrier layer doping region 1361 and the second barrier layer doping region 1362 may extend along the first direction D1 on a plane (e.g., FIG. 1). That is, the first barrier layer doping region 1361 and the second barrier layer doping region 1362 may have a rod shape that extends long along the first direction D1 on a plane. The first barrier layer doping region 1361 and the second barrier layer doping region 1362 may extend in directions parallel to each other. The first barrier layer doping region 1361 and the second barrier layer doping region 1362 may extend in a direction parallel to the gate electrode layer 155.

The first barrier layer doping region 1361 and the second barrier layer doping region 1362 may be formed in at least some regions of the barrier layer 136 by an ion injection method, for example, an ion-implantation (IIP) method.

The first barrier layer doping region 1361 and the second barrier layer doping region 1362 may include the same material as the barrier layer 136, for example, the first barrier layer doping region 1361 and the second barrier layer doping region 1362 may include a III-V group material, for example, a nitride including Al, Ga, In, B, or a combination thereof.

For example, the first barrier layer doping region 1361 and the second barrier layer doping region 1362 may each be doped as n-type. For example, the first barrier layer doping region 1361 and the second barrier layer doping region 1362 may each include AlₓIn_{y}Ga_{1-x-y}N (0≤x≤1, 0≤y≤1, x+y≤1), and may each be doped with silicon (Si) or germanium (Ge). In some implementations, the material, doping type, etc. of the first barrier layer doping region 1361 and the second barrier layer doping region 1362 may be variously changed.

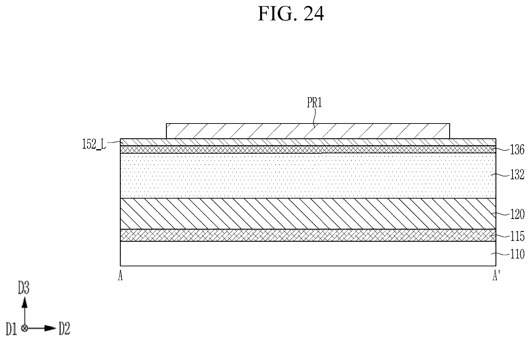

For example, as described later in FIGS. 24 to 32, the semiconductor device may be manufactured in the order of forming the first barrier layer doping region 1361, forming the gate electrode layer 155 and the gate semiconductor layer 152, and then forming the source electrode 173 connected to the first barrier layer doping region 1361.

In other words, by first forming the first barrier layer doping region 1361, which requires a high temperature process, the ohmic contact between the source electrode 173 and the channel layer 132 may be improved, thereby reducing the contact resistance, while by forming the gate electrode layer 155 and the gate semiconductor layer 152 before the source electrode 173, the alignment between the gate electrode layer 155 and the gate semiconductor layer 152 may also be improved.

Accordingly, the semiconductor device may further include the first barrier layer doping region 1361 and the first channel layer doping region 1321 located within the barrier layer 136. The first barrier layer doping region 1361 and the first channel layer doping region 1321 may improve the ohmic contact between the source electrode 173 and the channel layer 132.

Similarly, the semiconductor device may further include the second barrier layer doping region 1362 and the second channel layer doping region 1322 located within the barrier layer 136, wherein the second barrier layer doping region 1362 and the second channel layer doping region 1322 may improve the ohmic contact between the drain electrode 175 and the channel layer 132.

The gate electrode layer 155 may be located on the barrier layer 136. The gate electrode layer 155 may be overlapped with a portion of the barrier layer 136 in the third direction D3. The gate electrode layer 155 may be overlapped with a portion of the drift region DTR of the channel layer 132 in the third direction D3. The gate electrode layer 155 may be located between the source electrode 173 and the drain electrode 175 in the second direction D2. The gate electrode layer 155 may be spaced apart from the source electrode 173 and the drain electrode 175 in the second direction D2. The gate electrode layer 155 may extend along the first direction D1 on a plane. That is, the gate electrode layer 155 may have a bar shape extending long along the first direction D1 on a plane.

The gate electrode layer 155 may include a conductive material. For example, the gate electrode layer 155 may include a metal, a metal alloy, conductive metal nitride, metal silicide, a doped semiconductor material, conductive metal oxide, or conductive metal oxynitride. For example, the gate electrode layer 155 may be made of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt) , nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium. (Rh), palladium (Pd), iridium (Ir), osmium (Os), silver (Ag), gold (Au), zinc (Zn), vanadium (V), or a combination thereof. The gate electrode layer 155 may be made of a single layer or multiple layers.

The gate semiconductor layer 152 may be located between the barrier layer 136 and the gate electrode layer 155. That is, the gate semiconductor layer 152 may be located on the barrier layer 136, and the gate electrode layer 155 may be located on the gate semiconductor layer 152. The gate electrode layer 155 may be in Schottky contact with the gate semiconductor layer 152. In some cases, the gate electrode layer 155 may be in ohmic contact with the gate semiconductor layer 152. The gate semiconductor layer 152 may be overlapped with the gate electrode layer 155 in the third direction D3. The upper surface US_152 of the gate semiconductor layer 152 may be entirely covered by the gate electrode layer 155.

The gate semiconductor layer 152 may be located between the source electrode 173 and the drain electrode 175 in the second direction D2. The gate semiconductor layer 152 may be spaced apart from the source electrode 173 and the drain electrode 175 in the second direction D2. The gate semiconductor layer 152 may be located closer to the source electrode 173 than the drain electrode 175. That is, a separation distance between the gate semiconductor layer 152 and the source electrode 173 may be smaller than a separation distance between the gate semiconductor layer 152 and the drain electrode 175.

The gate semiconductor layer 152 may include nitride including Group III-V materials, for example, Al, Ga, In, B, or a combination thereof. The gate semiconductor layer 152 may include AlₓIn_{y}Ga_{1-x-y}N (0≤x≤1, 0≤y≤1, x+y≤1). For example, the gate semiconductor layer 152 may include AIN, GaN, InN, InGaN, AlGaN, AlInN, AlInGaN, or a combination thereof. The gate semiconductor layer 152 may include a material having an energy bandgap different from that of the barrier layer 136. For example, the gate semiconductor layer 152 may include GaN, and the barrier layer 136 may include AlGaN. The gate semiconductor layer 152 may be doped with a predetermined impurity. At this time, the impurity doped into the gate semiconductor layer 152 may be a p-type dopant that can provide holes. For example, the gate semiconductor layer 152 may include GaN doped with p-type impurities. That is, the gate semiconductor layer 152 may be made of a p-GaN layer. In some examples, the gate semiconductor layer 152 may be a p-AlGaN layer. The impurity doped into the gate semiconductor layer 152 may be magnesium (Mg). The gate semiconductor layer 152 may be made of a single layer or multiple layers.

A depletion region DPR may be formed in the channel layer 132 by the gate semiconductor layer 152. The depletion region DPR may be located within the drift region DTR and may have a narrower width than the drift region DTR. As the gate semiconductor layer 152 having a different energy bandgap from the barrier layer 136 is located on the barrier layer 136, a level of the energy band of a portion of the barrier layer 136 that is overlapped with the gate semiconductor layer 152 may increase. Accordingly, the depletion region DPR may be formed in the area of the channel layer 132 that is overlapped with the gate semiconductor layer 152. The depletion region DPR may be a region in the channel path of the channel layer 132 where the two-dimensional electron gas 134 is not formed or may have a lower electron concentration than the remaining regions. That is, the depletion region DPR may refer to a region where the flow of the two-dimensional electron gas 134 is interrupted within the drift region DTR. As the depletion region DPR is generated, current does not flow between the source electrode 173 and the drain electrode 175, and the channel path may be blocked. Accordingly, the semiconductor device may have normally-off characteristics.

That is, the semiconductor device may be a normally-off semiconductor device (HEMT, High Electron Mobility Transistor). In a normal state in which no voltage is applied to the gate electrode layer 155, a depletion region DPR exists and the semiconductor device may be in an off state. Although not shown, when a voltage higher than the threshold voltage is applied to the gate electrode layer 155, the depletion region DPR disappears, and the two-dimensional electron gas 134 may be connected without being disconnected within the drift region DTR. That is, the two-dimensional electron gas 134 may be formed throughout the channel path between the source electrode 173 and the drain electrode 175, and the semiconductor device may be in an on state. In summary, the semiconductor device may include semiconductor layers with different electrical polarization characteristics, and a semiconductor layer with a relatively high polarization rate can induce two-dimensional electron gas 134 in another semiconductor layer that forms heterojunction therewith. This two-dimensional electron gas 134 can be used as a channel between the source electrode 173 and the drain electrode 175, and the continuation or interruption of the flow of the two-dimensional electron gas 134 can be controlled by the bias voltage applied to the gate electrode layer 155. In the gate-off state, the flow of the two-dimensional electron gas 134 is blocked, and thus current may not flow between the source electrode 173 and the drain electrode 175. In the gate-on state, the two-dimensional electron gas 134 continues to flow, and thus current may flow between the source electrode 173 and the drain electrode 175.

Although the case where the semiconductor device is a normally-off high electron mobility transistor has been described above, the present disclosure may encompass other configurations and examples. For example, the semiconductor device may be a normally-on high electron mobility transistor. In the case of a normally-on high electron mobility transistor, the gate semiconductor layer 152 may be omitted, and accordingly, the gate electrode layer 155 may be located directly on the barrier layer 136. That is, the gate electrode layer 155 may contact the barrier layer 136. In some implementations, a gate insulation layer may be interposed between the gate electrode layer 155 and the barrier layer 136. In this structure, the two-dimensional electron gas 134 can be used as a channel while no voltage is applied to the gate electrode layer 155, and current may flow between the source electrode 173 and the drain electrode 175. Additionally, when a negative voltage is applied to the gate electrode layer 155, a depletion region DPR in which the flow of the two-dimensional electron gas 134 is cut off may be generated at the bottom of the gate electrode layer 155.

The buffer layer 120, channel layer 132, barrier layer 136, and gate semiconductor layer 152 described above may be sequentially stacked on the substrate 110. In the semiconductor device, at least one of the buffer layer 120, the channel layer 132, the barrier layer 136, and the gate semiconductor layer 152 may be omitted. The buffer layer 120, channel layer 132, barrier layer 136, and gate semiconductor layer 152 may be made of the same semiconductor material, and considering the role of each layer and the performance required for the semiconductor device, a material composition ratio of each layer may be different.

The semiconductor device may be manufactured by forming the gate semiconductor layer 152, covering the gate semiconductor layer 152 with the first protective layer 140, and then etching the first protective layer 140 to form the source electrode 173 and the gate electrode layer 155, unlike what will be described later in FIGS. 24 to 32. However, in this case, it is difficult to align the gate semiconductor layer 152 and the gate electrode layer 155.

Accordingly, the semiconductor device may be manufactured by first forming the gate electrode layer 155 and the gate semiconductor layer 152, and then forming the source electrode 173 connected to the first barrier layer doping region 1361. In this case, since the gate electrode layer 155 may be formed first, the gate semiconductor layer 152 may be formed using the gate electrode layer 155, and then the source electrode 173 may be formed, the gate semiconductor layer 152 and the gate electrode layer 155 may be self-aligned. The alignment between the gate electrode layer 155 and the gate semiconductor layer 152 is easy and excellent.

However, if the gate electrode layer 155 may be formed before the source electrode 173, there is a drawback in that a high temperature process for improving the ohmic contact between the source electrode 173 and the channel layer 132 may be impossible.

Accordingly, the semiconductor device may be manufactured by forming the first barrier layer doping region 1361, forming the gate electrode layer 155 and the gate semiconductor layer 152 first, and then forming the source electrode 173 connected to the first barrier layer doping region 1361, as described later in FIGS. 24 to 32.

In other words, by first forming the first barrier layer doping region 1361, which requires a high temperature process, the ohmic contact between the source electrode 173 and the channel layer 132 may be improved, thereby reducing the contact resistance, while by forming the gate electrode layer 155 and the gate semiconductor layer 152 before the source electrode 173, the alignment between the gate electrode layer 155 and the gate semiconductor layer 152 may also be improved.

Accordingly, the semiconductor device may further include a first barrier layer doping region 1361 and a first channel layer doping region 1321 located within the barrier layer 136. The first barrier layer doping region 1361 and the first channel layer doping region 1321 may improve the ohmic contact between the source electrode 173 and the channel layer 132.

Similarly, the semiconductor device may further include the second barrier layer doping region 1362 and the second channel layer doping region 1322 located within the barrier layer 136, wherein the second barrier layer doping region 1362 and the second channel layer doping region 1322 may improve the ohmic contact between the drain electrode 175 and the channel layer 132.

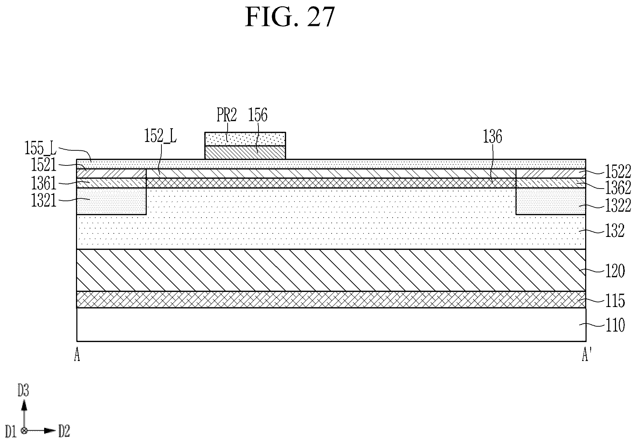

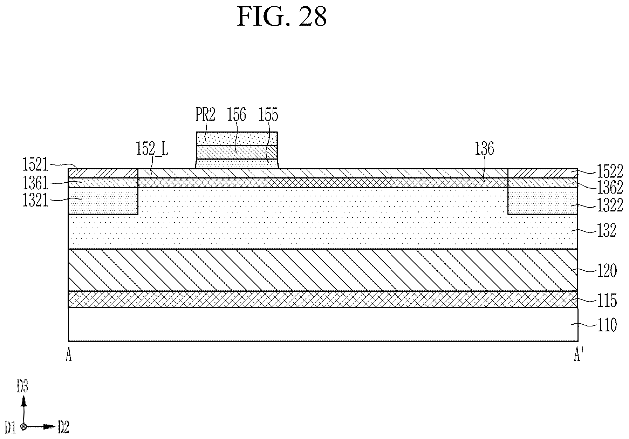

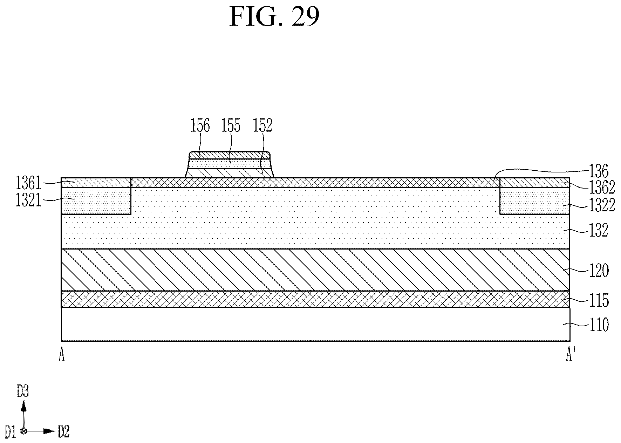

In addition, the semiconductor device may be manufactured by forming a gate electrode layer 155 by etching with a first etching gas using a second photoresist pattern PR2 of FIG. 27, as described later in FIGS. 28 and 29, removing the second photoresist pattern PR2, and forming a gate semiconductor layer 152 by etching with a second etching gas different from the first etching gas using a second hard mask layer 156 of FIG. 29. That is, since the gate electrode layer 155 may be formed using the second photoresist pattern PR2 and the gate semiconductor layer 152 may be formed using the second hard mask layer 156, the gate electrode layer 155 may be etched with the first etching gas and the gate semiconductor layer 152 may be etched with the second etching gas, so the degree of freedom in selecting the etching materials of the gate electrode layer 155 and the gate semiconductor layer 152 increases. Through this, the side slopes of the gate electrode layer 155 and the gate semiconductor layer 152 may be controlled in various ways.

For example, in a cross-sectional view cut in the second direction D2 and the third direction D3 (e.g., FIG. 3), an angle θ_155 formed by the lower surface BS_155 and the side surface SW_155 of the gate electrode layer 155 and an angle θ_152 formed by the lower surface BS_152 and the side surface SW_152 of the gate semiconductor layer 152 may be different from each other. For example, the angle θ_155 formed by the lower surface BS_155 and the side surface SW_155 of the gate electrode layer 155 may be greater than the angle θ_152 formed by the lower surface BS_152 and the side surface SW_152 of the gate semiconductor layer 152.

Herein, the gate electrode layer 155 may have, in a cross-sectional view cut in the second direction D2 and the third direction D3 (e.g., FIG. 3), an upper surface US_155 and a lower surface BS_155 facing each other in the third direction D3 and extending in the second direction D2, respectively, and both side surfaces SW_155 connecting the upper surface US_155 and the lower surface BS_155 and extending in the third direction D3. The upper surface US_155 of the gate electrode layer 155 may face the second hard mask layer 156, and the lower surface BS_155 of the gate electrode layer 155 may face the gate semiconductor layer 152. For example, the upper surface US_155 of the gate electrode layer 155 may be defined as a surface in contact with the second hard mask layer 156, the lower surface BS_155 of the gate electrode layer 155 may be defined as a surface in contact with the gate semiconductor layer 152, and both side surfaces SW_155 of the gate electrode layer 155 may be defined as surfaces that do not contact the second hard mask layer 156 and the gate semiconductor layer 152.

As an example, the angle θ_155 formed between the lower surface BS_155 and the side surface SW_155 of the gate electrode layer 155 may be greater than or equal to 60 °, for example, greater than 60 °, greater than or equal to 65 °, greater than or equal to 70 °, greater than or equal to 75 °, greater than or equal to 80°, or greater than or equal to 85°, and may be less than or equal to 90°, for example, less than 90°, less than or equal to 85°, less than or equal to 80°, less than or equal to 75°, less than or equal to 70°, or less than or equal to 65°, and may be 60° to 90°.

In addition, the angle θ_152 formed by the lower surface BS_152 and the side surface SW_152 of the gate semiconductor layer 152 may be greater than or equal to 30 °, for example, greater than 30 °, greater than or equal to 35 °, greater than or equal to 40 °, or greater than or equal to 45 °, greater than or equal to 50°, greater than or equal to 55°, greater than or equal to 60°, greater than 60°, greater than or equal to 65°, greater than or equal to 70°, greater than or equal to 75°, greater than or equal to 80°, or greater than or equal to 85°, and may be less than or equal to 89°, for example, less than 89°, less than or equal to 85°, less than or equal to 80°, less than or equal to 75°, less than or equal to 70°, less than or equal to 65°, less than or equal to 60°, less than 60°, less than or equal to 55°, less than or equal to 50°, less than or equal to 45°, less than or equal to 40°, or less than or equal to 35° and may be 30° to 89°.

Accordingly, in a cross-sectional view cut in the second direction D2 and the third direction D3 (e.g., FIG. 3), a length W_US_155 of the upper surface US_155 of the gate electrode layer 155 in the second direction D2 may be smaller than a length W_BS_155 of the lower surface BS_155 of the gate electrode layer 155 in the second direction D2.

Here, the length W_BS_155 of the lower surface BS_155 of the gate electrode layer 155 in the second direction D2 may be a length in the second direction D2 in which the lower surface BS_155 of the gate electrode layer 155 contacts the upper surface US_152 of the gate semiconductor layer 152, and may be a length excluding a length in the second direction D2 in which the lower surface BS_155 of the gate electrode layer 155 does not contact the upper surface US_152 of the gate semiconductor layer 152.

In addition, a length W_US_152 of the upper surface US_152 of the gate semiconductor layer 152 in the second direction D2 may be smaller than a length W_BS_152 of the lower surface BS_152 of the gate semiconductor layer 152 in the second direction D2. In addition, a difference (= W_BS_155 - W_US_155) in a length between the lower surface BS_155 and the upper surface US_155 of the gate electrode layer 155 in the second direction D2 may be smaller than a difference (= W_BS_152 - W_US_152) in a length between the lower surface BS_152 and the upper surface US_152 of the gate semiconductor layer 152 in the second direction D2. In this case, a contact area of the gate electrode layer 155 and the gate semiconductor layer 152 may be increased.

As described above, by-products generated when the gate electrode layer 155 is etched with the first etching gas may affect and cause defects when the gate semiconductor layer 152 may be etched with the second etching gas. In order to solve this problem, after etching the gate electrode layer 155 with a first etching gas, before etching the gate semiconductor layer 152 with a second etching gas, by-products generated when the gate electrode layer 155 is etched with the first etching gas can be removed through a process such as ashing or stripping. Accordingly, the problem of defects caused by by-products caused by etching the dissimilar materials of the gate electrode layer 155 and the gate semiconductor layer 152 with different etching materials can be solved.

In the process of removing by-products through processes such as ashing or stripping, the photoresist pattern PR may also be removed. During this process, the second hard mask layer 156 may be not removed. The second hard mask layer 156 may be used as a mask in a subsequent process of forming the gate semiconductor layer 152 using a second etching gas. When the gate semiconductor layer 152 is etched, the second hard mask layer 156 may be partially etched according to the etching conditions, and the second hard mask layer 156 may have a shape in which the edge formed by the upper surface US_156 and the side surface SW_156 may be rounded.

Accordingly, the semiconductor device may further include a second hard mask layer 156 located over the gate electrode layer 155. However, the second hard mask layer 156 may be removed depending on the etching conditions when the gate semiconductor layer 152 is etched.

If the second hard mask layer 156 includes the same material as the first protective layer 140, which will be described later, the boundary between the second hard mask layer 156 and the first protective layer 140 may not be distinguished.

In a cross-sectional view cut in the second direction D2 and the third direction D3 (e.g., FIG. 3), the second hard mask layer 156 may have an upper surface US_156 and a lower surface BS_156 that face each other in the third direction D3 and extend in the second direction D2, and both side surfaces SW_156 connecting the upper surface US_156 and the lower surface BS_156 and extending in the third direction D3.

The upper surface US_156 of the second hard mask layer 156 may extend from the midpoint of the second hard mask layer 156 in the second direction D2 to both ends of the second direction D2. The upper surface US_156 of the second hard mask layer 156 may have different heights in the second direction D2. For example, the height at both ends of the upper surface US_156 of the second hard mask layer 156 in the second direction D2 may be within ±30%, within ±20%, within ±10%, within ±5%, or within ±1% relative to the height at the midpoint of the second direction D2, and the point where the height exceeds ±30%, ±20%, ±10%, ±5%, or ±1% relative to the height at the midpoint of the second direction D2 may correspond to the side surface SW_156 of the second hard mask layer 156.

The lower surface BS_156 of the second hard mask layer 156 may extend from the midpoint of the second direction D2 to both ends of the second direction D2. The lower surface BS_156 of the second hard mask layer 156 may have different heights in the second direction D2. For example, the height at both ends of the upper surface BS_156 of the second hard mask layer 156 in the second direction D2 may be within ±30%, within ±20%, within ±10%, within ±5%, or within ±1% relative to the height at the midpoint of the second direction D2, and the point where the height exceeds ±30%, ±20%, ±10%, ±5%, or ±1% relative to the height at the midpoint of the second direction D2 may correspond to the side surface SW_156 of the second hard mask layer 156.

In a cross-sectional view cut in the second direction D2 and the third direction D3 (e.g., FIG. 3), the edge formed by the upper surface US_156 and the side surface SW_156 of the second hard mask layer 156 may have a round shape. In other words, the edge formed by the upper surface US_156 and the side surface SW_156 of the second hard mask layer 156 may not have an angular shape but may have an obliquely rounded shape, and for example, may have a curvature.

Accordingly, the angle θ_156U formed between the upper surface US_156 and the side surface SW_156 of the second hard mask layer 156 may become smaller as the distance from the upper surface US_156 of the second hard mask layer 156 in the third direction D3 increases. Herein, an angle θ_156U formed between the upper surface US_156 and the side surface SW_156 of the second hard mask layer 156 in the third direction D3 may be an interior angle of the tangent at a point on the side surface SW_156 and the upper surface US_156.

In addition, a ratio of the length W_US_156 of the upper surface US_156 of the second hard mask layer 156 in the second direction D2 and the length W_BS_156 of the lower surface BS_156 of the second hard mask layer 156 in the second direction D2 may be 9:10 or more, for example 9 : 10.5 or more, 9 : 11 or more, or 9 : 11.5 or more, and may be 9 : 12 or less, for example 9 : 11.5 or less, 9 : 11 or less, or 9 : 10.5 or less, and may be 9 : 10 to 9 : 12. The length W_US_156 of the upper surface US_156 of the second hard mask layer 156 in the second direction D2 may be the length measured by a substantially flat upper surface US_156 in the second direction D2 except for the rounded shape of the edge. Herein, flat may mean parallel to the second direction D2.

For example, in a cross-sectional view cut in the second direction D2 and the third direction D3 (e.g., FIG. 3), the angle θ_155 formed by the lower surface BS_155 and the side surface SW_155 of the gate electrode layer 155 and the angle θ_156U formed by the upper surface US_156 and the side surface SW_156 of the second hard mask layer 156 may be different from each other. For example, the angle θ_156U formed by the upper surface US_156 and the side surface SW_156 of the second hard mask layer 156 may be greater than the angle θ_155 formed by the lower surface BS_155 and the side surface SW_155 of the gate electrode layer 155.

As an example, the angle θ_156U formed between the upper surface US_156 and the side surface SW_156 of the second hard mask layer 156 may be greater than or equal to 90 °, for example, greater than 90 °, greater than or equal to 95 °, greater than or equal to 100 °, greater than or equal to 105 °, greater than or equal to 110°, or greater than or equal to 115°, and may be less than or equal to 120°, for example less than 120°, less than or equal to 115°, less than or equal to 110°, less than or equal to 105°, or less than or equal to 100°, or less than or equal to 95°, or less than or equal to 90°, and may be 90 ° to 120 °.

As an example, the second hard mask layer 156 may include silicon oxide, silicon nitride, silicon nitride, or a combination thereof.

The semiconductor device may further include first to third protective layers 140, 150, and 160 on the barrier layer 136, the gate electrode layer 155, and the second hard mask layer 156. As an example, the semiconductor device may include a first protective layer 140, a second protective layer 150 on the first protective layer 140, and a third protective layer 160 on the second protective layer 150. The first protective layer 140 may cover the barrier layer 136, the gate electrode layer 155, and the upper surface US_155 of the second hard mask layer 156, and may cover the side surface SW_155 of the gate electrode layer 155, the side surface SW_152 of the gate semiconductor layer 152, and the side surface SW_156 of the second hard mask layer 156. The lower surface of the first protective layer 140 may be in contact with the barrier layer 136, the gate electrode layer 155, the gate semiconductor layer 152, and the second hard mask layer 156. The upper surface of the first protective layer 140 may be in contact with the second protective layer 150. The second and third protective layers 150 and 160 may be spaced apart from the barrier layer 136, the gate electrode layer 155, the gate semiconductor layer 152, and the second hard mask layer 156 by the first protective layer 140. Accordingly, the second and third protective layers 150 and 160 may not contact the barrier layer 136, the gate electrode layer 155, the gate semiconductor layer 152, and the second hard mask layer 156.

The barrier layer 136 or the gate electrode layer 155 may be protected by the first to third protective layers 140, 150, and 160 and may be separated from other components. The first to third protective layers 140, 150, and 160 may include an insulating material. For example, the first to third protective layers 140, 150, and 160 may include an oxide such as SiO₂ or Al₂O₃. As another example, the first to third protective layers 140, 150, and 160 may include nitride such as SiN or oxynitride such as SiON. The first to third protective layers 140, 150, and 160 may include the same material or different materials. If the first to third protective layers 140, 150, and 160 are made of the same material, boundaries between the first to third protective layers 140, 150, and 160 may not be visible. The first to third protective layers 140, 150, and 160 may each be made of a single layer or multiple layers.

For example, the first protective layer 140 may be located on the barrier layer 136, the first barrier layer doping region 1361, and the second barrier layer doping region 1362. A lower surface of the first protective layer 140 may contact the upper surface of the barrier layer 136, the upper surface of the first barrier layer doping region 1361, and the upper surface of the second barrier layer doping region 1362. Additionally, the first protective layer 140 may be located on the gate electrode layer 155 and the gate semiconductor layer 152. A lower surface of the first protective layer 140 may contact the upper surface and side surface of the gate electrode layer 155 and the side surface of the gate semiconductor layer 152. When the second hard mask layer 156 is located on the gate electrode layer 155, the lower surface of the first protective layer 140 may contact the upper surface and side surface of the second hard mask layer 156, the side surface of the gate electrode layer 155, and the side surface of the gate semiconductor layer 152.

As described above, the semiconductor device is manufactured by first forming the gate electrode layer 155 and the gate semiconductor layer 152, then forming the first protective layer 140 covering the barrier layer 136, the gate semiconductor layer 152, the gate electrode layer 155, the first barrier layer doping region 1361, and the second barrier layer doping region 1362, etching a part of the first protective layer 140 to expose the first barrier layer doping region 1361 and the second barrier layer doping region 1362, forming the source electrode 173 on the first barrier layer doping region 1361, and forming the drain electrode 175 on the second barrier layer doping region 1362, so that the first protective layer 140 may cover the entire gate electrode layer 155.

In this case, the alignment between the gate electrode layer 155 and the gate semiconductor layer 152 may be improved.

On the other hand, when forming the gate semiconductor layer 152, covering the gate semiconductor layer 152 with the first protective layer 140, and then etching the first protective layer 140 to form the source electrode 173 and the gate electrode layer 155, the upper portion of the gate electrode layer 155 may be located on the first protective layer 140.

Additionally, the gate electrode layer 155 and the gate semiconductor layer 152 may be connected only by a via penetrating the first protective layer 140. In other words, in a cross-section cut in the second direction D2 and in the third direction D3 (e.g., FIG. 3), a length W_US_155 of an upper surface US_155 of the gate electrode layer 155 in the second direction D2 may be greater than a length W_BS_155 of a lower surface BS_155 of the gate electrode layer 155 in the second direction D2. In this case, the alignment between the gate electrode layer 155 and the gate semiconductor layer 152 may be difficult, and the contact area between the gate electrode layer 155 and the gate semiconductor layer 152 may be small.

The source electrode 173 and the drain electrode 175 may be located on the channel layer 132. The source electrode 173 and the drain electrode 175 may be spaced apart from each other in the second direction D2, and the second hard mask layer 156, the gate electrode layer 155, and the gate semiconductor layer 152 may be located between the source electrode 173 and the drain electrode 175. The second hard mask layer 156, the gate electrode layer 155, and the gate semiconductor layer 152 may be spaced apart from the source electrode 173 and the drain electrode 175 in the second direction D2.

The source electrode 173 may be electrically connected to the channel layer 132 on a side of the gate electrode layer 155 in the second direction D2. The source electrode 173 may be electrically connected to the channel layer 132 through the first barrier layer doping region 1361 and the first channel layer doping region 1321. The first barrier layer doping region 1361 and the first channel layer doping region 1321 may be in ohmic contact with the source electrode 173. The contact resistance between the source electrode 173 and the channel layer 132 may be reduced by the first barrier layer doping region 1361 and the first channel layer doping region 1321.

The drain electrode 175 may be electrically connected to the second channel layer doping region 1322 on the other side of the gate electrode layer 155 in the second direction D2. The drain electrode 175 may be electrically connected to the channel layer 132 through the second barrier layer doping region 1362 and the second channel layer doping region 1322. The second barrier layer doping region 1362 and the second channel layer doping region 1322 may be in ohmic contact with the drain electrode 175. The contact resistance between the drain electrode 175 and the channel layer 132 may be reduced by the second barrier layer doping region 1362 and the second channel layer doping region 1322.

The source electrode 173 and the drain electrode 175 may be located outside or on the drift region (DTR) of the channel layer 132. The boundary between the source electrode 173 and the channel layer 132 may be one edge of the drift region DTR. Likewise, the boundary between the drain electrode 175 and the channel layer 132 may be the other edge of the drift region DTR.

For example, the source electrode 173 may penetrate the first protective layer 140 and be located on the first barrier layer doping region 1361 and the first channel layer doping region 1321, and the drain electrode 175 may penetrate the first protective layer 140 and be located on the second barrier layer doping region 1362 and the second channel layer doping region 1322. At this time, the first barrier layer doping region 1361 and the first channel layer doping region 1321 may not be recessed, and the source electrode 173 may be located on the upper surface of the first barrier layer doping region 1361. The lower surface of the source electrode 173 may contact the upper surface of the first barrier layer doping region 1361. Similarly, the second barrier layer doping region 1362 and the second channel layer doping region 1322 may not be recessed, and the drain electrode 175 may be located on the upper surface of the second barrier layer doping region 1362. The lower surface of the drain electrode 175 may contact the upper surface of the second barrier layer doping region 1362.

A length W_173 of the source electrode 173 in the second direction D2 may be greater than or equal to a length W_1361 of the first barrier layer doping region 1361 in the second direction D2. Additionally, the length W_173 of the source electrode 173 in the second direction D2 may be greater than or equal to a length W_1321 of the first channel layer doping region 1321 in the second direction D2. For example, the length W_173 of the source electrode 173 in the second direction D2 may be greater than the length W_1361 of the first barrier layer doping region 1361 in the second direction D2 or the length W_1321 of the first channel layer doping region 1321 in the second direction D2 by greater than 0 µm and less than or equal to 0.8 µm.

Similarly, a length of the drain electrode 175 in the second direction D2 may be greater than or equal to a length of the second barrier layer doping region 1362 in the second direction D2. Additionally, the length of the drain electrode 175 in the second direction D2 may be greater than or equal to a length of the first channel layer doping region 1321 in the second direction D2. For example, the length of the drain electrode 175 in the second direction D2 may be greater than the length of the second barrier layer doping region 1362 in the second direction D2 or the length of the second channel layer doping region 1322 in the second direction D2 by greater than 0 µm and less than or equal to 0.8 µm.

In this case, the source electrode 173 and the drain electrode 175 may not be located on a side of the drift region DTR of the channel layer 132 the second direction D2, but may be located on the drift region DTR in the third direction D3. For example, the drift region DTR may extend from the channel layer 132 to the first channel layer doping region 1321 and the second channel layer doping region 1322, and thus the source electrode 173 and the drain electrode 175 may be located on the drift region DTR.

As described above, the first barrier layer doping region 1361, the first channel layer doping region 1321, the second barrier layer doping region 1362, and the second channel layer doping region 1322 may be doped at high concentration. At this time, the carriers passing through the two-dimensional electron gas 134 may be transferred to the source electrode 173 and the drain electrode 175 through the first barrier layer doping region 1361, the first channel layer doping region 1321, the second barrier layer doping region 1362, and the second channel layer doping region 1322, which may be doped with high concentration. The source electrode 173 and drain electrode 175 may not be in direct contact with the two-dimensional electron gas 134 in the horizontal direction. The horizontal direction may mean a direction parallel to the upper surface of the channel layer 132 or barrier layer 136.

The source electrode 173 and the drain electrode 175 may extend in the first direction D1 on a plane. That is, the source electrode 173 and the drain electrode 175 may have a rod shape that extends long along the first direction D1 on a plane. The source electrode 173 and the drain electrode 175 may be extended in a direction parallel to each other. The source electrode 173 and the drain electrode 175 may extend in a direction parallel to the gate electrode layer 155.

The source electrode 173 and drain electrode 175 may include conductive material. For example, the source electrode 173 and the drain electrode 175 may include a metal, a metal alloy, conductive metal nitride, metal silicide, a doped semiconductor material, conductive metal oxide, or conductive metal oxynitride. For example, the source electrode 173 and the drain electrode 175 may be made of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAIN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt) , nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium. (Rh), palladium (Pd), iridium (Ir), osmium (Os), silver (Ag), gold (Au), zinc (Zn), vanadium (V), or a combination thereof. The source electrode 173 and the drain electrode 175 may be made of a single layer or multiple layers.

The source electrode 173 may include the lower source electrode 173a, the middle source electrode 173b, and the upper source electrode 173c. The middle source electrode 173b may be located on the lower source electrode 173a. The upper source electrode 173c may be located on the middle source electrode 173b. The lower source electrode 173a may be in direct contact with the first barrier layer doping region 1361 or the first channel layer doping region 1321 and may be electrically connected to the channel layer 132. The middle source electrode 173b and the upper source electrode 173c may not be in direct contact with the channel layer 132 and may be electrically connected to the channel layer 132 through the lower source electrode 173a.

The drain electrode 175 may include the lower drain electrode 175a, the middle drain electrode 175b, and the upper drain electrode 175c. The middle drain electrode 175b may be located on the lower drain electrode 175a. The upper drain electrode 175c may be located on the middle drain electrode 175b. The lower drain electrode 175a may be in direct contact with the second barrier layer doping region 1362 or the second channel layer doping region 1322 and may be electrically connected to the channel layer 132. The middle drain electrode 175b and the upper drain electrode 175c may not be in direct contact with the channel layer 132 and may be electrically connected to the channel layer 132 through the lower drain electrode 175a.

The upper surfaces of the lower source electrode 173a and the lower drain electrode 175a may be located on the first protective layer 140. The upper surfaces of the lower source electrode 173a and the lower drain electrode 175a may be located between the first protective layer 140 and the second protective layer 160. The lower source electrode 173a and the lower drain electrode 175a penetrate the first protective layer 140 and the barrier layer 136, and the trenches recessing the upper surface of the channel layer 132 may be located on both sides of the gate electrode (layer) 155 to be spaced apart from each other. The lower source electrode 173a and the lower drain electrode 175a may be located in the trench on both sides of the gate electrode (layer) 155, respectively. The lower source electrode 173a and the lower drain electrode 175a may be formed to fill the trench. Within the trench, the lower source electrode 173a may be in contact with the first barrier layer doping region 1361 or the first channel layer doping region 1321. Additionally, the lower drain electrode 175a within the trench may be in contact with the second barrier layer doping region 1362 or the second channel layer doping region 1322. The first channel layer doping region 1321 or the second channel layer doping region 1322 may form a lower surface and a sidewall of the trench, and the first barrier layer doping region 1361 or the second barrier layer doping region 1362 may form a sidewall of the trench. Therefore, the lower source electrode 173a and the lower drain electrode 175a may be in contact with the upper surface and the side surface of the first channel layer doping region 1321 or the second channel layer doping region 1322. Additionally, the lower source electrode 173a and the lower drain electrode 175a may be in contact with the side surface of the first barrier layer doping region 1361 or the second barrier layer doping region 1362.

The upper surfaces of the lower source electrode 173a and the lower drain electrode 175a may protrude relative to the upper surface of the first protective layer 140. Additionally, at least one of the lower source electrode 173a and the lower drain electrode 175a may cover at least a part of the upper surface of the first protective layer 140. The second protective layer 150 may be located on the lower source electrode 173a and the lower drain electrode 175a. At least a part of the lower source electrode 173a and the lower drain electrode 175a may be covered by the second protective layer 150.

The semiconductor device may further include a first field dispersion layer 177a on the first protective layer 140. The first field dispersion layer 177a may be located between the source electrode 173 and the drain electrode 175. The gate electrode layer 155 may be covered by the first field dispersion layer 177a. The first field dispersion layer 177a may be electrically connected to the source electrode 173. For example, the first field dispersion layer 177a may be connected to the lower source electrode 173a. The first field dispersion layer 177a may include the same material as the lower source electrode 173a and may be located in the same layer as the lower source electrode 173a. The first field dispersion layer 177a may be formed simultaneously with the lower source electrode 173a in the same process. The boundary between the first field dispersion layer 177a and the lower source electrode 173a may not be clear, and the first field dispersion layer 177a may be formed integrally with the lower source electrode 173a. In some implementations, the first field dispersion layer 177a may be a separate element from the lower source electrode 173a. Additionally, the first field dispersion layer 177a may be located in a different layer from the lower source electrode 173a and may be formed in a different process. In some cases, the first field dispersion layer 177a may be electrically connected to the gate electrode layer 155. For example, an opening that is overlapped with the gate electrode layer 155 may be formed in the first protective layer 140, and the first field dispersion layer 177a may be connected to the gate electrode layer 155 through the opening. At this time, the first field dispersion layer 177a may not be connected to the source electrode 173.

The semiconductor device may further include a second field dispersion layer 177b located on the second protective layer 150. The second field dispersion layer 177b may form a field dispersion layer together with the first field dispersion layer 177a. The second field dispersion layer 177b may be located between the source electrode 173 and the drain electrode 175. The second field dispersion layer 177b may be overlapped with the gate electrode layer 155 in the third direction D3. The second field dispersion layer 177b may be overlapped with the first field dispersion layer 177a in the third direction D3. The gate electrode layer 155 and the first field dispersion layer 177a may be covered by the second field dispersion layer 177b. The second field dispersion layer 177b may be wider than the first field dispersion layer 177a. The second field dispersion layer 177b may entirely cover the first field dispersion layer 177a. In some implementations, the width and positional relationship of the first field dispersion layer 177a and the second field dispersion layer 177b may be changed in various ways. The second field dispersion layer 177b may be electrically connected to the source electrode 173. For example, the second field dispersion layer 177b may be connected to the middle source electrode 173b. The second field dispersion layer 177b may include the same material as the middle source electrode 173b and may be located in the same layer as the middle source electrode 173b. The second field dispersion layer 177b may be formed simultaneously with the middle source electrode 173b in the same process. The boundary between the second field dispersion layer 177b and the middle source electrode 173b may not be clear, and the second field dispersion layer 177b may be formed integrally with the middle source electrode 173b. In some implementations, the second field dispersion layer 177b may be a separate component separated from the middle source electrode 173b. Additionally, the second field dispersion layer 177b may be located in a different layer from the middle source electrode 173b and may be formed in a different process.

The semiconductor device may further include a third field dispersion layer 177c on the third protective layer 160. The third field dispersion layer 177c may form a field dispersion layer together with the first field dispersion layer 177a and the second field dispersion layer 177b. The third field dispersion layer 177c may be located between the source electrode 173 and the drain electrode 175. The third field dispersion layer 177c may be overlapped with the gate electrode layer 155 in the third direction D3. The third field dispersion layer 177c may be overlapped with the first field dispersion layer 177a and the second field dispersion layer 177b in the third direction D3. The gate electrode layer 155, the first field dispersion layer 177a, and the second field dispersion layer 177b may be covered by the third field dispersion layer 177c. The third field dispersion layer 177c may have a larger width than the second field dispersion layer 177b. The third field dispersion layer 177c may entirely cover the second field dispersion layer 177b. In some implementations, the width and positional relationship of the first field dispersion layer 177a, the second field dispersion layer 177b, and the third field dispersion layer 177c may be changed in various ways. The third field dispersion layer 177c may be electrically connected to the source electrode 173. For example, the third field dispersion layer 177c may be connected to the upper source electrode 173c. The third field dispersion layer 177c may include the same material as the upper source electrode 173c and may be located in the same layer as the upper source electrode 173c. The third field dispersion layer 177c may be formed simultaneously in the same process as the upper source electrode 173c. The boundary between the third field dispersion layer 177c and the upper source electrode 173c may not be clear, and the third field dispersion layer 177c may be formed integrally with the upper source electrode 173c. In some implementations, the third field dispersion layer 177c may be a separate element separated from the upper source electrode 173c. Additionally, the third field dispersion layer 177c may be located in a different layer from the upper source electrode 173c and may be formed in a different process.

In some implementations, at least one of the first field dispersion layer 177a, the second field dispersion layer 177b, or the third field dispersion layer 177c may be omitted. For example, the semiconductor device may include the first field dispersion layer 177a and may not include the second field dispersion layer 177b or the third field dispersion layer 177c. Alternatively, the semiconductor device may include the second field dispersion layer 177b and not include the first field dispersion layer 177a or the third field dispersion layer 177c. Alternatively, the semiconductor device may include the third field dispersion layer 177c and not include the first field dispersion layer 177a or the second field dispersion layer 177b. Alternatively, the semiconductor device may not include the first field dispersion layer 177a, the second field dispersion layer 177b, and the third field dispersion layer 177c.

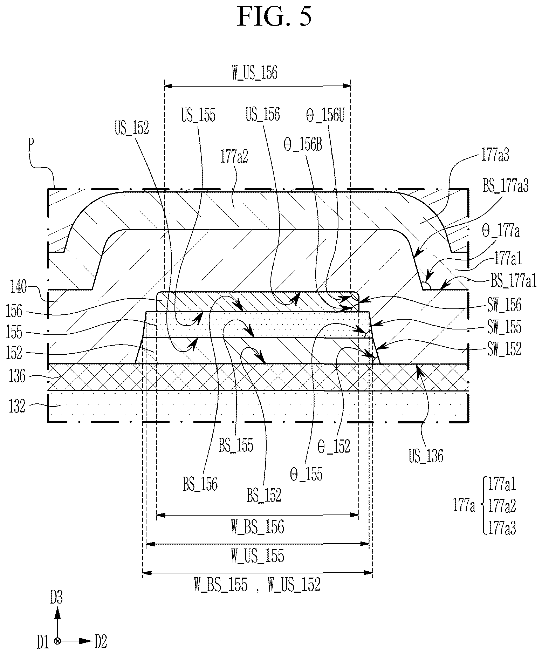

FIG. 5 is an enlarged cross-sectional view of portion P of FIG. 2, showing another implementation.

Since the implementation shown in FIG. 5 has many of the same parts as the implementation shown in FIG. 3, the description thereof will be omitted and the differences will be mainly explained. Additionally, the same reference numerals are used for the same components as those in the previous implementation.

Referring to FIG. 5, the length W_BS_156 of the second hard mask layer 156 in the second direction D2 of the lower surface BS_156 may be reduced depending on the etching conditions when etching the gate semiconductor layer 152.

Accordingly, in the cross-sectional view cut in the second direction D2 and the third direction D3 (e.g., FIG. 5), the length W_BS_156 of the lower surface BS_156 of the second hard mask layer 156 in the second direction D2 may be smaller than the length W_US_155 of the upper surface of the gate electrode layer 155 in the second direction D2.

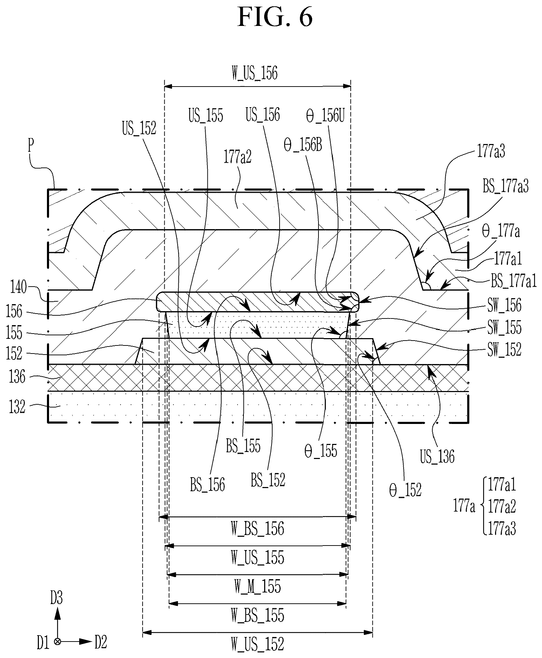

FIG. 6 is an enlarged cross-sectional view of portion P of FIG. 2, showing another implementation.

Since the implementation shown in FIG. 6 has many of the same parts as the implementation shown in FIG. 3, the description thereof will be omitted and the differences will be mainly explained. Additionally, the same reference numerals are used for the same components as those in the previous implementation.

Referring to FIG. 6, the gate electrode layer 155 may have a length W_US_155 in the second direction D2 of the upper surface US_155 and a length W_BS_155 in the second direction D2 of the lower surface BS_155 depending on the etch condition during etching of the gate semiconductor layer 152. Referring to FIG. 6, the length W_US_155 of the upper surface US_155 in the second direction D2 and the length W_BS_155 of the lower surface BS_155 in the second direction D2 may be reduced depending on the etching conditions when etching the gate semiconductor layer 152.

In a cross-sectional view cut in the second direction D2 and the third direction D3 (e.g., FIG. 6), the length W_US_155 of the upper surface US_155 of the gate electrode layer 155 in the second direction D2 and the length W_BS_155 of the lower surface BS_155 in the second direction D2 may be smaller than the length W_BS_156 of the lower surface BS_156 of the hard mask layer 156 in the second direction D2 and the length W_US_152 of the upper surface US_152 of the gate semiconductor layer 152 in the second direction D2.

In addition, the length W_BS_155 of the lower surface BS_155 of the gate electrode layer 155 in the second direction D2 may be smaller than the length W_US_155 of the upper surface US_155 of the gate electrode layer 155 in the second direction D2. Accordingly, in a cross-sectional view cut in the second direction D2 and the third direction D3 (e.g., FIG. 6), the gate electrode layer 155 may have an inverted trapezoidal shape.

As described above, the second hard mask layer 156 may be partially etched according to the etching conditions when etching the gate semiconductor layer 152, and in the second hard mask layer 156, the edge formed by the upper surface US_156 and the side surface SW_156 as well as the edge formed by the lower surface BS_156 and the side surface SW_156 may have a rounded shape.

In a cross-section cut in the second direction D2 and in the third direction D3 (e.g., FIG. 6), the edge formed by the lower surface BS_156 and the side surface SW_156 of the second hard mask layer 156 may have a rounded shape. In other words, the edge formed by the lower surface BS_156 and the side surface SW_156 of the second hard mask layer 156 may not have an angular shape but may have an obliquely cut round shape, for example, may have a curvature.

The angle θ_156B formed between the lower surface BS_156 and the side surface SW_156 of the second hard mask layer 156 may become smaller as the distance from the lower surface BS_156 of the hard mask layer 156 in the third direction D3 increases. Herein, the angle θ_156B formed between the lower surface BS_156 and the side surface SW_156 of the second hard mask layer 156 in the third direction D3 may be an interior angle of the tangent at a point on the side surface SW_156 and the lower surface BS_156.

As an example, the angle θ_156B formed by the lower surface BS_156 and the side surface SW_156 of the second hard mask layer 156 may be greater than or equal to 90 °, for example, greater than 90 °, greater than or equal to 95 °, greater than or equal to 100 °, greater than or equal to 105 °, greater than or equal to 110°, or greater than or equal to 115°, and may be less than or equal to 120°, for example less than 120°, less than or equal to 115°, less than or equal to 110°, less than or equal to 105°, or less than or equal to 100°, or less than or equal to 95°, or less than or equal to 90°, and may be 90 ° to 120 °.

The rounded shape of the edge formed by the upper surface US_156 and the side surface SW_156 of the second hard mask layer 156 may be gentler than the rounded shape of the edge formed by the lower surface BS_156 and the side surface SW_156 of the second hard mask layer 156 and the rounded shape of the edge formed by the bottom surface BS_156 and the side surface SW_156 of the second hard mask layer 156 may be steeper than the rounded shape of the edge formed by the upper surface US_156 and the side surface SW_156 of the second hard mask layer 156. In other words, the curvature of the edge formed by the upper surface US_156 and the side surface SW_156 of the second hard mask layer 156 may be smaller than the curvature of the edge formed by the lower surface BS_156 and the side surface SW_156 of the second hard mask layer 156.

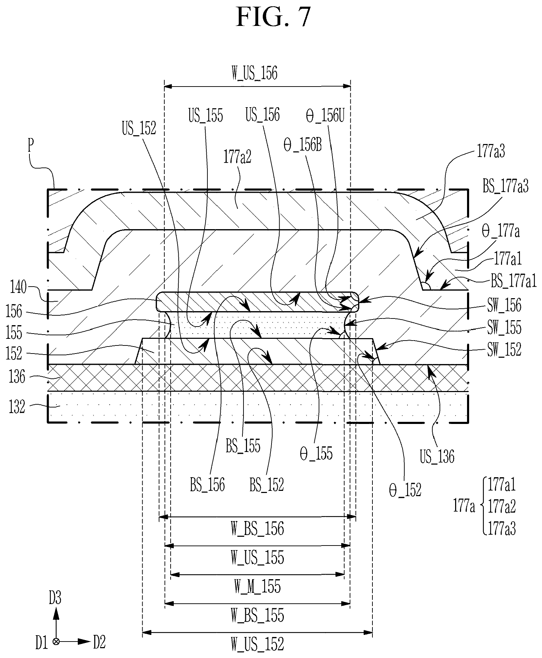

FIG. 7 is an enlarged cross-sectional view of portion P of FIG. 2, showing another implementation.

Since the implementation shown in FIG. 7 has many of the same parts as the implementation shown in FIG. 6, the description thereof will be omitted and the differences will be mainly explained. Additionally, the same reference numerals are used for the same components as those in the previous implementation.

In FIG. 6, the length W_BS_155 of the lower surface BS_155 in the second direction D2 may be reduced more than the length W_US_155 of the upper surface US_155 in the second direction D2, according to the etching conditions when the gate semiconductor layer 152 is etched. It is further reduced than the length W_US_155 in D2, and in a cross-sectional view cut in the second direction D2 and the third direction D3 (e.g., FIG. 6), the gate electrode layer 155 is shown to have an inverted trapezoidal shape. In this case, the length W_M_155 from the midpoint in the third direction D3 between the upper surface US_155 and the lower surface BS_155 of the gate electrode layer 155 in the second direction D2 may be smaller than the length W_US_155 of the upper surface US_155 of the gate electrode layer 155 in the second direction D2 and may be larger than the length W_BS_155 of the lower surface BS_155 in the second direction D2.

Referring to FIG. 7, when the gate electrode layer 155 is etched, depending on the etching conditions, both side surfaces SW_155 of the gate electrode layer 155 have a concave shape toward the gate electrode layer 155.

Accordingly, the length W_M_155 from the midpoint in the third direction D3 between the upper surface US_155 and the lower surface BS_155 of the gate electrode layer 155 in the second direction D2 may be smaller than the length W_US_155 of the upper surface US_155 of the gate electrode layer 155 in the second direction D2 and the length W_BS_155 of the lower surface BS_155 in the second direction D2.

For example, the length of the gate electrode layer 155 in the second direction D2 may approximately decrease from the upper surface US_155 of the gate electrode layer 155 to the midpoint of the third direction D3 in the third direction D3 and then after having a minimum value near the midpoint of the third direction D3, it may approximately increase from the midpoint of the third direction D3 to the lower surface BS_155.

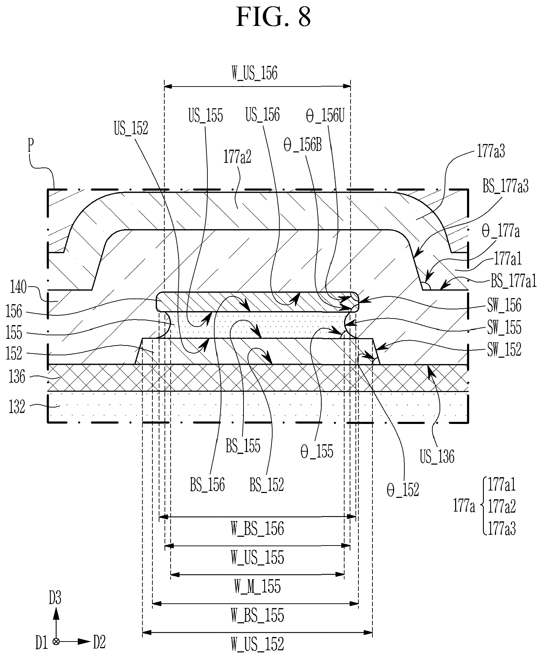

FIG. 8 is an enlarged cross-sectional view of portion P of FIG. 2, showing another implementation.

Since the implementation shown in FIG. 8 has many of the same parts as the implementation shown in FIG. 7, the description thereof will be omitted and the differences will be mainly explained. Additionally, the same reference numerals are used for the same components as those in the previous implementation.

In FIG. 7, the length W_M_155 from the midpoint in the third direction D3 between the upper surface US_155 and the lower surface BS_155 of the gate electrode layer 155 in the second direction D2 may be smaller than the length W_US_155 of the upper surface US_155 of the gate electrode layer 155 in the second direction D2 and the length W_BS_155 of the lower surface BS_155 in the second direction D2, but the length W_US_155 of the upper surface US_155 of the gate electrode layer 155 in the second direction D2 and the length W_BS_155 of the lower surface BS_155 in the second direction D2 are shown to be approximately similar.

Referring to FIG. 8, the length W_M_155 from the midpoint in the third direction D3 between the upper surface US_155 and the lower surface BS_155 of the gate electrode layer 155 in the second direction D2 may be smaller than the length W_US_155 of the upper surface US_155 of the gate electrode layer 155 in the second direction D2 and the length W_BS_155 of the lower surface BS_155 of the gate electrode layer 155 in the second direction D2. The length W_US_155 of the upper surface US_155 of the gate electrode layer 155 in the second direction D2 may be smaller than the length W_BS_155 of the lower surface BS_155 of the gate electrode layer 155 in the second direction D2. FIG. 8 shows that the length W_BS_155 of the lower surface BS_155 of the gate electrode layer 155 in the second direction D2 may be greater than the length W_US_156 of the upper surface US_156 and the length W_BS_156 of the lower surface BS_156 of the hard mask layer 156, but this is illustrative. As another example, in the second direction D2, the length W_BS_155 of the lower surface BS_155 of the gate electrode layer 155 may be smaller than the length W_US_156 of the upper surface US_156 and the length W_BS_156 of the lower surface BS_156 of the hard mask layer 156.

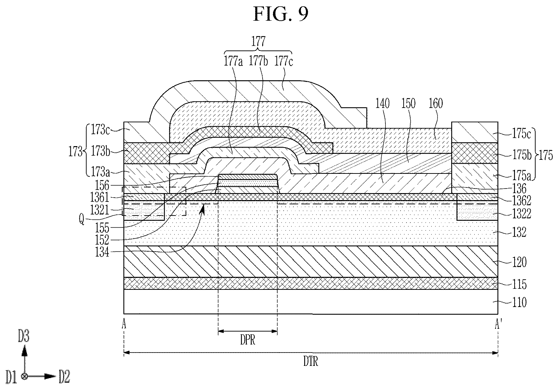

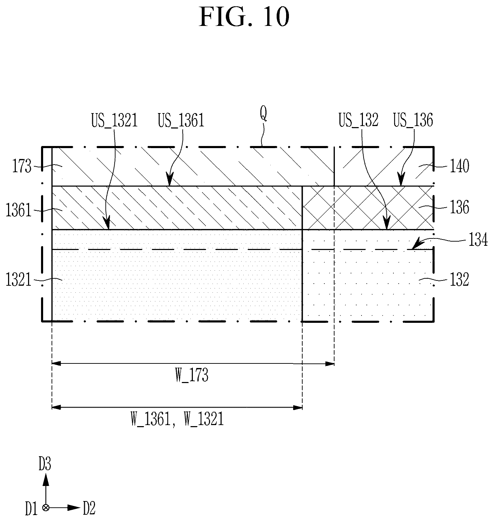

FIG. 9 is a cross-sectional view taken along line A-A' of FIG. 1, showing another implementation. FIG. 10 is an enlarged cross-sectional view of portion Q of FIG. 9.

Since the implementations shown in FIGS. 9 and 10 have many of the same parts as the implementations shown in FIGS. 2 and 4, the description thereof will be omitted and the differences will be mainly explained. Additionally, the same reference numerals are used for the same components as those in the previous implementation.

Referring to FIGS. 9 and 10, the length W_173 of the source electrode 173 in the second direction D2 may be smaller than or equal to the length W_1361 of the first barrier layer doping region 1361 in the second direction D2. Additionally, the length W_173 of the source electrode 173 in the second direction D2 may be smaller than or equal to the length W_1321 of the first channel layer doping region 1321 in the second direction D2. For example, the length W_173 of the source electrode 173 in the second direction D2 may be smaller the length W_1361 of the first barrier layer doping region 1361 in the second direction D2 or the length W_1321 of the first channel layer doping region 1321 in the second direction D2 by greater than 0 µm and less than or equal to 0.2 µm.

Similarly, the length of the drain electrode 175 in the second direction D2 may be less than or equal to the length of the second barrier layer doping region 1362 in the second direction D2. Additionally, the length of the drain electrode 175 in the second direction D2 may be greater than or equal to the length of the second channel layer doping region 1322 in the second direction D2. For example, the length of the drain electrode 175 in the second direction D2 may be smaller than the length of the second barrier layer doping region 1362 in the second direction D2 or the length of the second channel layer doping region 1322 in the second direction D2 by greater than 0 µm and less than or equal to 0.2 µm.

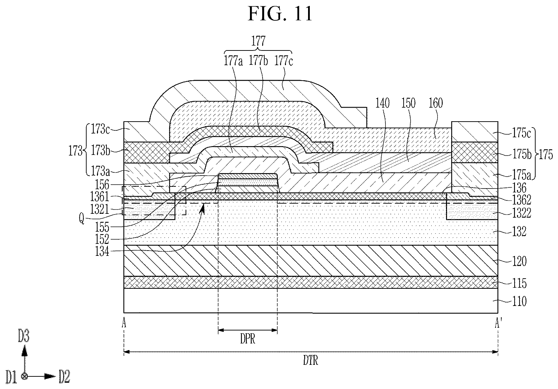

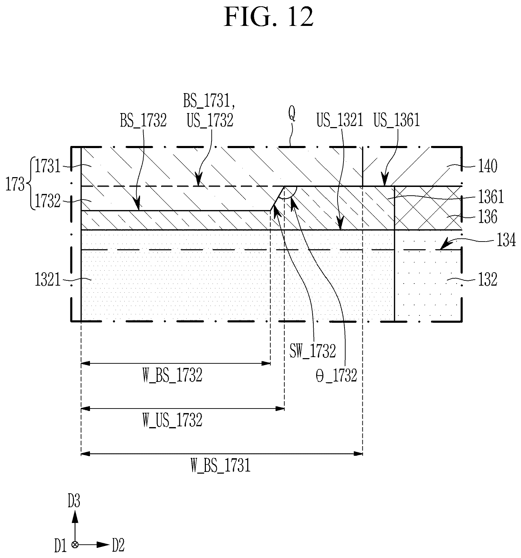

FIG. 11 is a cross-sectional view taken along line A-A' of FIG. 1, showing another implementation. FIG. 12 is an enlarged cross-sectional view of portion Q of FIG. 11.

Since the implementations shown in FIGS. 11 and 12 have many of the same parts as the implementations shown in FIGS. 2 and 4, the description thereof will be omitted and the differences will be mainly explained. Additionally, the same reference numerals are used for the same components as those in the previous implementation.

Referring to FIGS. 11 and 12, the source electrode 173 may have a first portion 1731 and a second portion 1732.

The first portion 1731 may be located on the first barrier layer doping region 1361. A lower surface BS_1731 of the first portion 1731 may contact an upper surface US_1361 of the first barrier layer doping region 1361.

The second portion 1732 may be located under the first portion 1731. A lower surface BS_1731 of the first portion 1731 may contact an upper surface US_1732 of the second portion 1732. The second portion 1732 may be located within the first barrier layer doping region 1361. For example, the second portion 1732 may protrude from the first portion 1731 toward the first barrier layer doping region 1361 and be located within the first barrier layer doping region 1361. A side SW_1732 of the second portion 1732 in the second direction D2 may contact a side of the first barrier layer doping region 1361 in the second direction D2.

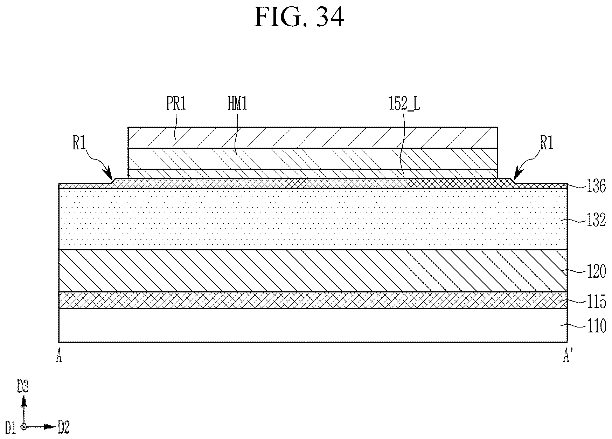

As described later in FIG. 34, when the first gate semiconductor material layer 152_L of FIG. 34 is etched to expose the barrier layer 136, a part of a surface of the barrier layer 136 may be etched to form a first recess R1 of FIG. 34 on a surface of the barrier layer 136, so that a side SW_1732 of the second portion 1732 in the second direction D2 may have a slope. In this case, the contact area between the source electrode 173 and the first barrier layer doping region 1361 may be increased, and the electric field concentration may be alleviated.

For example, a length W_US_1732 of the upper surface US_1732 of the second portion 1732 in the second direction D2 may be smaller than a length W_BS_1732 of the lower surface BS_1732 of the second portion 1732 in the second direction D2.

An angle θ_1732 formed by a side surface SW_1732 of the second portion 1732 in the second direction D2 and an upper surface US_1361 of the first barrier layer doping region 1361 may be greater than or equal to 90°, for example, greater than 90°, greater than or equal to 95°, greater than or equal to 100°, greater than or equal to 105°, greater than or equal to 110°, or greater than or equal to 115°, and may be less than or equal to 120°, for example, less than 120°, less than or equal to 115°, less than or equal to 110°, less than or equal to 105°, less than or equal to 100°, or less than or equal to 95°, and may be 90° to 120°.

Additionally, a length W_US_1732 of the upper surface US_1732 of the second portion 1732 in the second direction D2 may be smaller than a length W_BS_1731 of the lower surface BS_1731 of the first portion 1731 in the second direction D2. In other words, a part of the lower surface BS_1731 of the first portion 1731 may be in contact with the upper surface US_1732 of the second portion 1732, and another part of the lower surface BS_1731 of the first portion 1731, which does not contact the upper surface US_1732 of the second portion 1732, may be in contact with the upper surface US_1361 of the first barrier layer doping region 1361.

For example, the second portion 1732 may extend down the third direction D3 but may not penetrate the first barrier layer doping region 1361. The lower surface BS_1732 of the second portion 1732 may not contact the upper surface US_1321 of the first channel layer doping region 1321. A part of the first barrier layer doping region 1361 may be located between the second portion 1732 and the first channel layer doping region 1321.

In other words, a level of the lower surface BS_1732 of the second portion 1732 in the third direction D3 may be higher than a level of the lower surface of the first barrier layer doping region 1361 in the third direction D3 and may be higher than a level of the upper surface US_1321 of the first channel layer doping region 1321 in the third direction. A level of the lower surface BS_1732 of the second portion 1732 in the third direction D3 may be lower than a level of the upper surface US_1361 of the first barrier layer doping region 1361 in the third direction D3. A level of the lower surface BS_1732 of the second portion 1732 in the third direction D3 may be located within the first barrier layer doping region 1361.

Similarly, the drain electrode 175 may have a first portion and a second portion.

The first portion of the drain electrode 175 may be located on the second barrier layer doping region 1362. The second portion may be located below the first portion. The second portion may be located within the second barrier layer doping region 1362. For example, the second portion may protrude from the first portion toward the second barrier layer doping region 1362 and be located within the second barrier layer doping region 1362.

A side of the second portion in the second direction D2 may have a slope. For example, a length of an upper surface of the second portion in the second direction D2 may be smaller than a length of a lower surface of the second portion in the second direction D2. Additionally, the length of the upper surface of the second portion in the second direction D2 may be smaller than a length of a lower surface of the first portion in the second direction D2. Additionally, the second portion may extend down the third direction D3 but may not penetrate the second barrier layer doping region 1362.

A description of the first portion and the second portion of the drain electrode 175 is the same as the description of the first portion 1731 and second portion 1732 of the source electrode 173, so a repeated description is omitted.

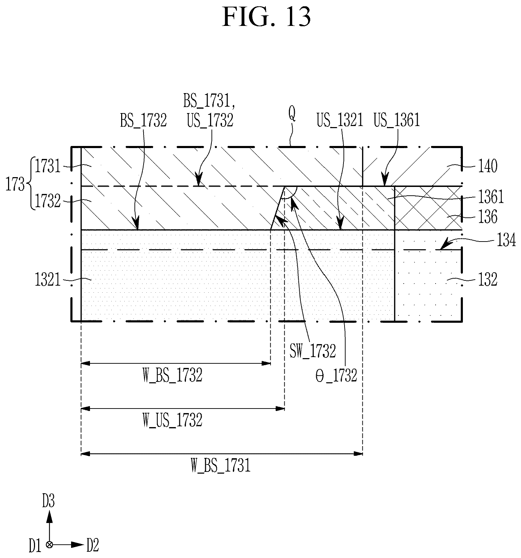

FIG. 13 is an enlarged cross-sectional view of portion Q of FIG. 11, showing another implementation.

Since the implementation shown in FIG. 13 has many of the same parts as the implementation shown in FIG. 12, the description thereof will be omitted and the differences will be mainly explained. Additionally, the same reference numerals are used for the same components as those in the previous implementation.

Referring to FIG. 13, the second portion 1732 of the source electrode 173 may extend down the third direction D3 and penetrate the first barrier layer doping region 1361. The second portion 1732 may be connected to the first channel layer doping region 1321. The lower surface BS_1732 of the second portion 1732 may be contacted with the upper surface US_1321 of the first channel layer doping region 1321.

In other words, the level of the lower surface BS_1732 of the second portion 1732 in the third direction D3 may be equal to the level of the lower surface of the first barrier layer doping region 1361 in the third direction D3 and may be equal to the level of the upper surface US_1321 of the first channel layer doping region 1321 in the third direction.

Similarly, the second portion of the drain electrode 175 may extend down the third direction D3 and penetrate the second barrier layer doping region 1362. The second portion may be connected to the second channel layer doping region 1322.

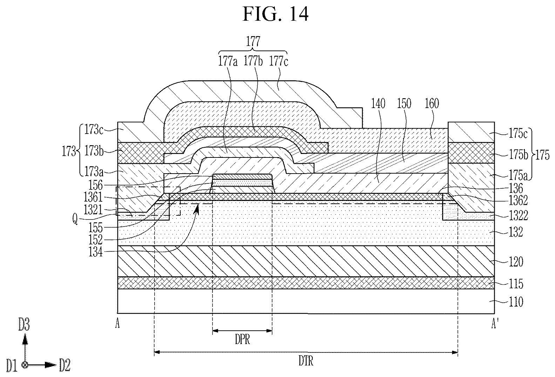

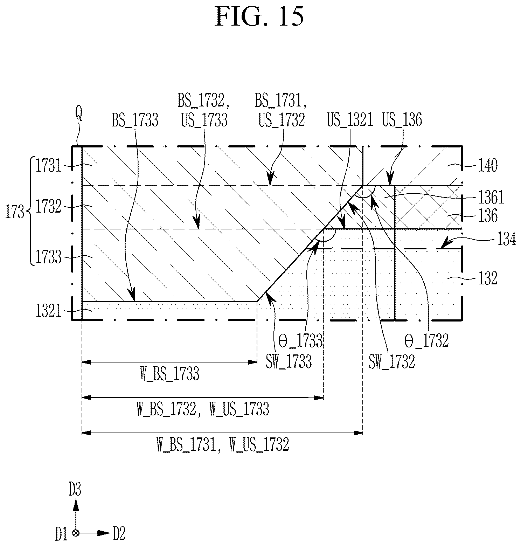

FIG. 14 is a cross-sectional view taken along line A-A' of FIG. 1, showing another implementation. FIG. 15 is an enlarged cross-sectional view of portion Q of FIG. 14.

Since the implementations shown in FIGS. 14 and 15 have many of the same parts as the implementations shown in FIGS. 11 and 13, the description thereof will be omitted and the differences will be mainly explained. Additionally, the same reference numerals are used for the same components as those in the previous implementation.

Referring to FIGS. 14 and 15, the source electrode 173 may further have a third portion 1733.

Third portion 1733 may be located under second portion 1732. The lower surface BS_1732 of the second portion 1732 may contact an upper surface US_1733 of the third portion 1733. The third portion 1733 may be located within the first channel layer doping region 1321. For example, the third portion 1733 may protrude from the second portion 1732 toward the first channel layer doping region 1321 and be located within the first channel layer doping region 1321. A side SW_1733 of the third portion 1733 in the second direction D2 may contact the side of the first channel layer doping region 1321 in second direction D2.

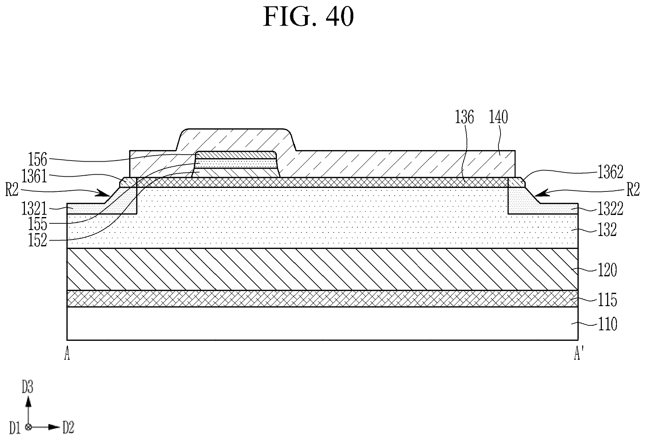

As described later in FIG. 40, when the first protective layer 140 is formed and a part of the first protective layer 140 may be etched to expose the first channel layer doping region 1321, a part of the surface of the first channel layer doping region 1321 may be etched to form a second recess R2 of FIG. 40 on the surface of the first channel layer doping region 1321, so that a side SW_1733 of the third portion 1733 in the second direction D2 may have a slope. In this case, the contact area between the source electrode 173 and the first channel layer doping region 1321 may be increased, and the electric field concentration may be alleviated.

For example, a length W_US_1733 of an upper surface US_1733 of the third portion 1733 in the second direction D2 may be smaller than a length W_BS_1732 of a lower surface BS_1733 of the third portion 1733 in the second direction D2.

A angle θ_1733 formed by a side surface SW_1733 of the third portion 1733 in the second direction D2 and the upper surface US_1321 of the first channel layer doping region 1321 may be greater than or equal to 90°, for example, greater than 90°, greater than or equal to 95°, greater than or equal to 100°, greater than or equal to 105°, greater than or equal to 110°, or greater than or equal to 115°, and may be less than or equal to 120°, for example, less than 120°, less than or equal to 115°, less than or equal to 110°, less than or equal to 105°, less than or equal to 100°, or less than or equal to 95°, and may be 90° to 120°.

In some implementations, the length W_US_1733 of the upper surface US_1733 of the third portion 1733 in the second direction D2 may be smaller than the length W_BS_1732 of the lower surface BS_1732 of the second portion 1732 in the second direction D2. In other words, a part of the lower surface BS_1732 of the second portion 1732 may be in contact with the upper surface US_1733 of the third portion 1733, and another part of the lower surface BS_1732 of the second portion 1732, which does not contact the upper surface US_1733 of the third portion 1733, may be in contact with the upper surface US_1321 of the first channel layer doping region 1321.

The second portion 1732 of the source electrode 173 may extend down the third direction D3 and penetrate the first barrier layer doping region 1361. The second portion 1732 may be connected to the first channel layer doping region 1321. The lower surface BS_1732 of the second portion 1732 may be contacted with the upper surface US_1321 of the first channel layer doping region 1321.

In other words, the level of the lower surface BS_1732 of the second portion 1732 in the third direction D3 may be equal to the level of the lower surface of the first barrier layer doping region 1361 in the third direction D3 and may be equal to the level of the upper surface US_1321 of the first channel layer doping region 1321 in the third direction.

The third portion 1733 of the source electrode 173 extends below the third direction D3 but may not penetrate the first channel layer doping region 1321. The third portion 1733 does not contact the lower surface of the first channel layer doping region 1321, and a part of the first channel layer doping region 1321 may be located between the third portion 1733 and the lower surface of the first channel layer doping region 1321.

In other words, the level of the lower surface BS_1733 of the third portion 1733 in the third direction D3 may be lower than the level of the lower surface of the first barrier layer doping region 1361 in the third direction D3, and may be lower than the level of the upper surface US_1321 of the first channel layer doping region 1321 in the third direction D3.

In addition, the level of the third direction D3 of the lower surface BS_1733 of the third portion 1733 may be higher than the level of the third direction D3 of the lower surface of the first channel layer doping region 1321, and the third direction D3 of the lower surface BS_1733 of the third portion 1733 may be located within the first channel layer doping region 1321.

Similarly, the drain electrode 175 may have a third portion.

The third portion of the drain electrode 175 may be located below the second portion. The third portion may be located within the second channel layer doping region 1322. For example, the third portion may protrude from the second portion toward the second channel layer doping region 1322 and be located within the second channel layer doping region 1322. A side of the third portion in the second direction D2 may have a slope. A length of an upper surface of the third portion in the second direction D2 may be smaller than a length of a lower surface of the third portion in the second direction D2. The third portion extends down in the third direction D3 but may not penetrate the second channel layer doping region 1322.

The description of the third portion of the drain electrode 175 is the same as the description of the third portion 1733 of the source electrode 173, so a repeated description is omitted.

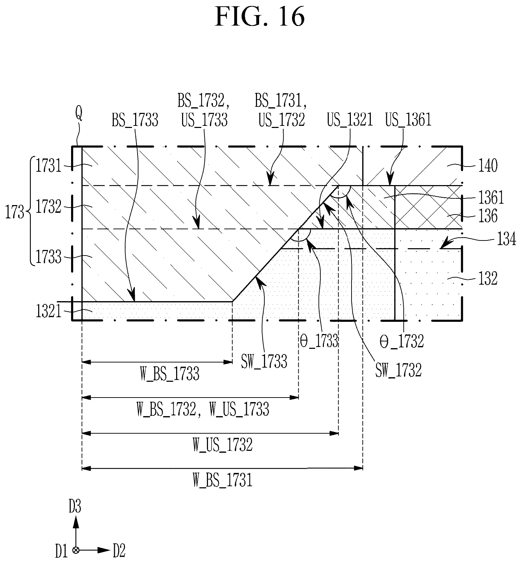

FIG. 16 is an enlarged cross-sectional view of portion Q of FIG. 14, showing another implementation.

Since the implementation shown in FIG. 16 has many of the same parts as the implementation shown in FIG. 15, the description thereof will be omitted and the differences will be mainly explained. Additionally, the same reference numerals are used for the same components as those in the previous implementation.

Referring to FIG. 16, the length W_US_1732 of the upper surface US_1732 of the second portion 1732 in the second direction D2 may be smaller than the length W_BS_1731 of the lower surface BS_1731 of the first portion 1731 in the second direction D2. In other words, a part of the lower surface BS_1731 of the first portion 1731 may be in contact with the upper surface US_1732 of the second portion 1732, and another part of the lower surface BS_1731 of the first portion 1731, which does not contact the upper surface US_1732 of the second portion 1732, may be in contact with the upper surface US_1361 of the first barrier layer doping region 1361.

The length W_US_1732 of the upper surface US_1732 of the second portion 1732 in the second direction D2 may be smaller than the length W_BS_1732 of the lower surface BS_1732 of the second portion 1732 in the second direction D2.

Additionally, the length W_US_1733 of the upper surface US_1733 of the third portion 1733 in the second direction D2 may be equal to the length W_BS_1732 of the lower surface BS_1732 of the second portion 1732 in the second direction D2.

In some implementations, the length W_US_1733 of the upper surface US_1733 of the third portion 1733 in the second direction D2 may be smaller than the length W_BS_1732 of the lower surface BS_1732 of the second portion 1732 in the second direction D2. In other words, a part of the lower surface BS_1732 of the second portion 1732 may be in contact with the upper surface US_1733 of the third portion 1733, and another part of the lower surface BS_1732 of the second portion 1732, which does not contact the upper surface US_1733 of the third portion 1733, may be in contact with the upper surface US_1321 of the first channel layer doping region 1321.

The length W_US_1733 of the upper surface US_1733 of the third portion 1733 in the second direction D2 may be smaller than the length W_BS_1733 of the lower surface BS_1733 of the third portion 1733 in the second direction D2.

The angle θ_1732 formed by the side surface SW_1732 of the second portion 1732 in the second direction D2 and the upper surface US_1361 of the first barrier layer doping region 1361 may be equal to the angle θ_1733 formed by the side surface SW_1733 of the third portion 1733 in the second direction D2 and the upper surface US_1321 of the first channel layer doping region 1321.

In some implementations, the angle θ_1732 between the side surface SW_1732 of the second portion 1732 in the second direction D2 and the upper surface US_1361 of the first barrier layer doping region 1361 may be different from the angle θ_1733 between the side surface SW_1733 of the third portion 1733 in the second direction D2 and the upper surface US_1321 of the first channel layer doping region 1321. For example, the angle θ_1732 formed by the side surface SW_1732 of the second portion 1732 in the second direction D2 and the upper surface US_1361 of the first barrier layer doping region 1361 may be greater than or less than the angle θ_1733 formed by the side surface SW_1733 of the third portion 1733 in the second direction D2 and the upper surface US_1321 of the first channel layer doping region 1321.

Similarly, the length of the upper surface of the second portion of the drain electrode 175 in the second direction D2 may be smaller than the length of the lower surface of the first portion in the second direction D2. The length of the upper surface of the third portion in the second direction D2 may be smaller than the length of the lower surface of the second portion in the second direction D2. The angle formed by the side surface of the second portion in the second direction D2 and the upper surface of the second barrier layer doping region 1362 may be equal to or different from the angle formed by the side surface of the third portion in the second direction D2 and the upper surface of the second channel layer doping region 1322.

The description of the first to third portions of the drain electrode 175 is the same as the description of the first to third portions 1731, 1732, and 1733 of the source electrode 173, so a repeated description is omitted.

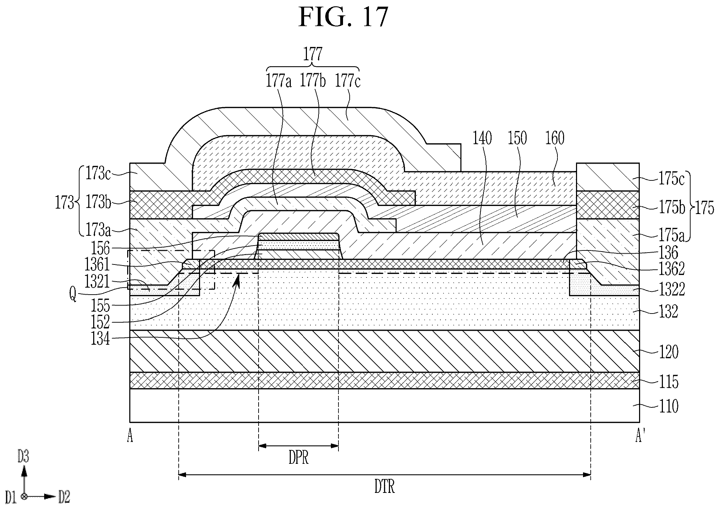

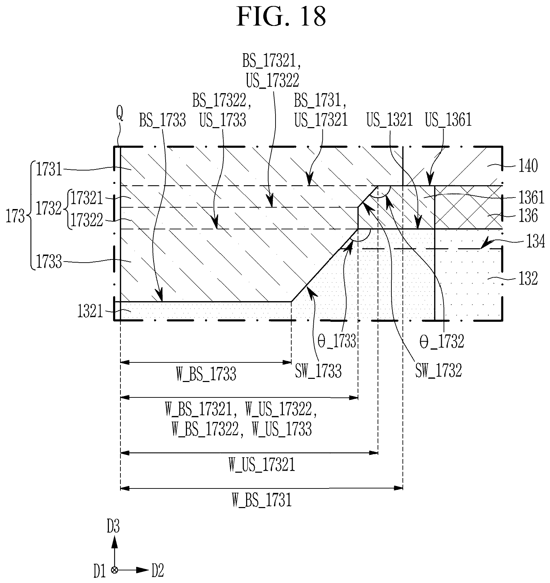

FIG. 17 is a cross-sectional view taken along line A-A' of FIG. 1, showing another implementation. FIG. 18 is an enlarged cross-sectional view of portion Q of FIG. 17.

Since the implementations shown in FIGS. 17 and 18 have many of the same parts as the implementations shown in FIGS. 14 and 15, the description thereof will be omitted and the differences will be mainly explained. Additionally, the same reference numerals are used for the same components as those in the previous implementation.

Referring to FIGS. 17 and 18, the second portion 1732 of the source electrode 173 may further have a second-1 portion 17321 and a second-2 portion 17322.

The second-1 portion 17321 may be located under the first portion 1731. The second-2 portion 17322 may be located under the second-1 portion 17321. The second-2 portion 17322 may be located between the second-1 portion 17321 and the first channel layer doping region 1321. Alternatively, the second-2 portion 17322 may be located between the second-1 portion 17321 and the third portion 1733. The second-1 portion 17321 and the second-2 portion 17322 may be located within the first barrier layer doping region 1361.

For example, a length W_US_17321 of an upper surface US_17321 of the second-1 portion 17321 in the second direction D2 may be greater than or equal to a length W_BS_17321 of a lower surface BS_17321 of the second-1 portion 17321 in the second direction D2.

The length W_BS_17321 of the lower surface BS_17321 of the second-1 portion 17321 in the second direction D2 may be greater than or equal to the length W_US_17322 of the upper surface US_17322 of the second-2 portion 17322 in the second direction D2.

The length W_US_17322 of the upper surface US_17322 of the second-2 portion 17322 in the second direction D2 may be greater than or equal to the length W_BS_17322 of the lower surface BS_17322 of the second-2 portion 17322 in the second direction D2.

The length W_US_17321 of the upper surface US_17321 of the second-1 portion 17321 in the second direction D2 may be greater than the length W_BS_17322 of the lower surface BS_17322 of the second-2 portion 17322 in the second direction D2.

For example, in FIG. 18, the length W_US_17321 of the upper surface US_17321 of the second-1 portion 17321 in the second direction D2 may be greater than the length W_BS_17321 of the lower surface BS_17321 of the second-1 portion 17321 in the second direction D2, the length W_BS_17321 of the lower surface BS_17321 of the second-1 portion 17321 in the second direction D2 may be equal to the length W_US_17322 of the upper surface US_17322 of the second-2 portion 17322 in the second direction D2, and the length W_US_17322 of the upper surface US_17322 of the second-2 portion 17322 in the second direction D2 may be equal to the length W_BS_17322 of the lower surface BS_17322 of the second-2 portion 17322 in the second direction D2.

Similarly, the second portion of the drain electrode 175 may also have a second-1 portion and a second-2 portion.

The description of the second portion of the drain electrode 175 is the same as the description of the second portion 1732 of the source electrode 173, so a repeated description is omitted.

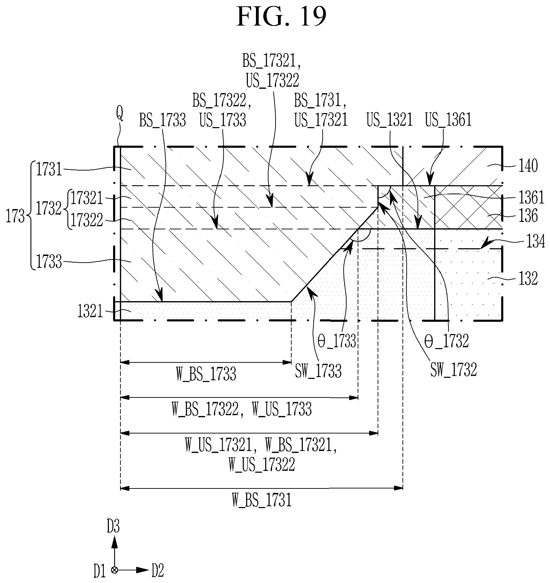

FIG. 19 is an enlarged cross-sectional view of portion Q of FIG. 18, showing another implementation.

Since the implementation shown in FIG. 19 has many of the same parts as the implementation shown in FIG. 18, the description thereof will be omitted and the differences will be mainly explained. Additionally, the same reference numerals are used for the same components as those in the previous implementation.

Referring to FIG. 19, the length W_US_17321 of the upper surface US_17321 of the second-1 portion 17321 in the second direction D2 may be equal to the length W_BS_17321 of the lower surface BS_17321 of the second-1 portion 17321 in the second direction D2, the length W_BS_17321 of the lower surface BS_17321 of the second-1 portion 17321 in the second direction D2 may be equal to the length W_US_17322 of the upper surface US_17322 of the second-2 portion 17322 in the second direction D2, and the length W_US_17322 of the upper surface US_17322 of the second-2 portion 17322 in the second direction D2 may be greater than the length W_BS_17322 of the lower surface BS_17322 of the second-2 portion 17322 in the second direction D2.

The description of the second portion of drain electrode 175 is the same as the description of the second portion 1732 of source electrode 173, so a repeated description is omitted.

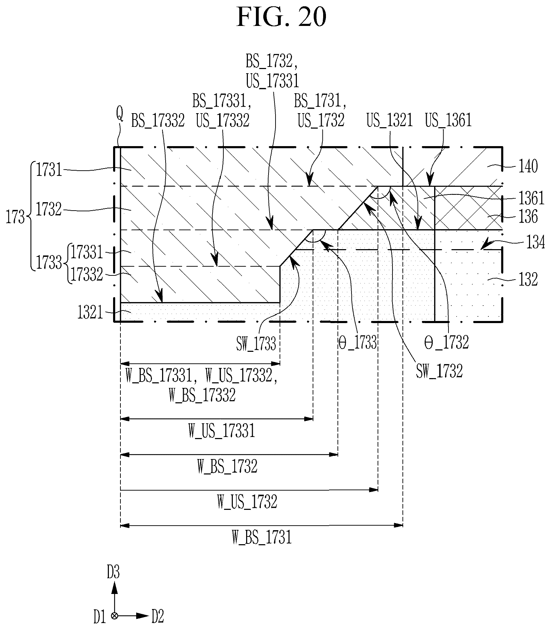

FIG. 20 is an enlarged cross-sectional view of portion Q of FIG. 17, showing another implementation.

Since the implementation shown in FIG. 20 has many of the same parts as the implementation shown in FIG. 18, the description thereof will be omitted and the differences will be mainly explained. Additionally, the same reference numerals are used for the same components as those in the previous implementation.

The third portion 1733 of the source electrode 173 may further have a third-1 portion 17331 and a third-2 portion 17332.

The third-1 portion 17331 may be located under the second portion 1732. The third-2 portion 17332 may be located under the third-1 portion 17331. The third-2 portion 17332 may be located between the third-1 portion 17331 and the first channel layer doping region 1321. the third-1 portion 17331 and the third-2 portion 17332 may be located within the first channel layer doping region 1321.

For example, a length W_US_17331 of an upper surface US_17331 of the third-1 portion 17331 in the second direction D2 may be greater than or equal to a length W_BS_17331 of a lower surface BS_17331 of the third-1 portion 17331 in the second direction D2.

A length W_BS_17331 of a lower surface BS_17331 of the third-1 portion 17331 in the second direction D2 may be greater than or equal to a length W_US_17332 of an upper surface US_17332 of the third-2 portion 17332 in the second direction D2.

The length W_US_17332 of the upper surface US_17332 of the third-2 portion 17332 in the second direction D2 may be greater than or equal to a length W_BS_17322 of a lower surface BS_17332 of the third-2 portion 17332 in the second direction D2.

The length W_US_17331 of the upper surface US_17331 of the third-1 portion 17331 in the second direction D2 may be greater than the length W_BS_17332 of the lower surface BS_17332 of the third-2 portion 17332 in the second direction D2.

Referring to FIG. 20, the length W_US_17331 of the upper surface US_17331 of the third-1 portion 17331 in the second direction D2 may be greater than the length W_BS_17331 of the lower surface BS_17331 of the third-1 portion 17331 in the second direction D2, the length W_BS_17331 of the lower surface BS_17331 of the third-1 portion 17331 in the second direction D2 may be equal to the length W_US_17332 of the upper surface US_17332 of the third-2 portion 17332 in the second direction D2, and the length W_US_17332 of the upper surface US_17332 of the third-2 portion 17332 in the second direction D2 may be equal to the length W_BS_17332 of the lower surface BS_17332 of the third-2 portion 17332 in the second direction D2.

Similarly, the third portion of the drain electrode 175 may also have a third-1 portion and a third-2 portion.

The description of the third portion of the drain electrode 175 is the same as the description of the third portion 1733 of the source electrode 173, so a repeated description is omitted.

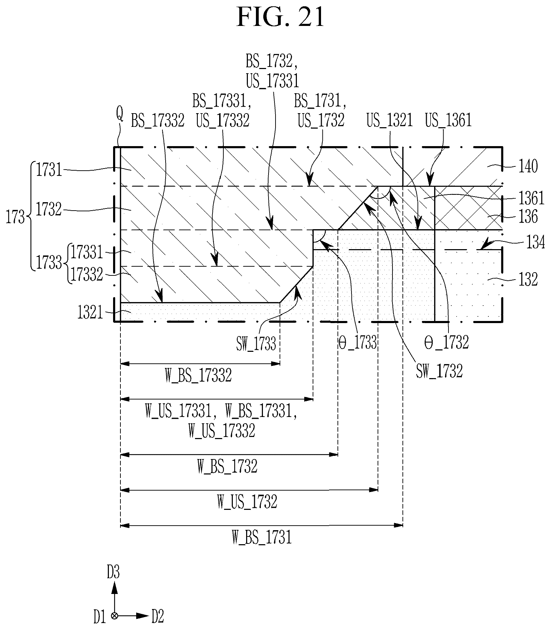

FIG. 21 is an enlarged cross-sectional view of portion Q of FIG. 17, showing another implementation.

Since the implementation shown in FIG. 21 has many of the same parts as the implementation shown in FIG. 20, the description thereof will be omitted and the differences will be mainly explained. Additionally, the same reference numerals are used for the same components as those in the previous implementation.

Referring to FIG. 21, the length W_US_17331 of the upper surface US_17331 of the third-1 portion 17331 in the second direction D2 may be equal to the length W_BS_17331 of the lower surface BS_17331 of the third-1 portion 17331 in the second direction D2, the length W_BS_17331 of the lower surface BS_17331 of the third-1 portion 17331 in the second direction D2 may be equal to the length W_US_17332 of the upper surface US_17332 of the third-2 portion 17332 in the second direction D2, and the length W_US_17332 of the upper surface US_17332 of the third-2 portion 17332 in the second direction D2 may be greater than the length W_BS_17332 of the lower surface BS_17332 of the third-2 portion 17332 in the second direction D2.

The description of the third portion of drain electrode 175 is the same as the description of the third portion 1733 of source electrode 173, so a repeated description is omitted.

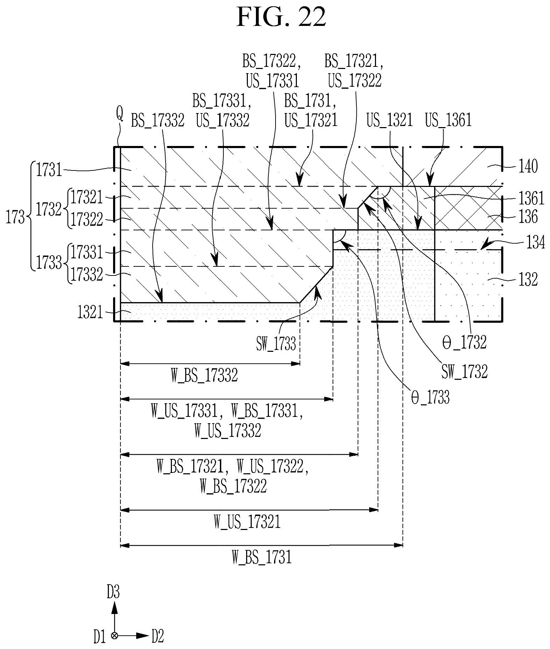

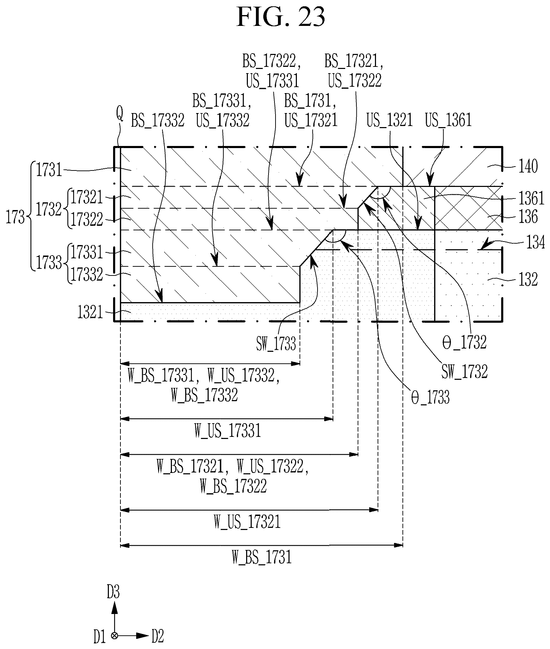

FIGS. 22 and 23 are enlarged cross-sectional views of portion Q of FIG. 17, showing another implementation.

Since the implementation shown in FIGS. 22 and 23 have many of the same parts as the implementation shown in FIG. 18, the description thereof will be omitted and the differences will be mainly explained. Additionally, the same reference numerals are used for the same components as those in the previous implementation.

Referring to FIGS. 22 and 23, the second portion 1732 of the source electrode 173 may further have the second-1 portion 17321 and the second-2 portion 17322, and the third portion 1733 of the source electrode 173 may further have the third-1 portion 17331 and the third-2 portion 17332.

In FIG. 22, the length W_US_17321 of the upper surface US_17321 of the second-1 portion 17321 in the second direction D2 may be greater than the length W_BS_17321 of the lower surface BS_17321 of the second-1 portion 17321 in the second direction D2, the length W_BS_17321 of the lower surface BS_17321 of the second-1 portion 17321 in the second direction D2 may be equal to the length W_US_17322 of the upper surface US_17322 of the second-2 portion 17322 in the second direction D2, and the length W_US_17322 of the upper surface US_17322 of the second-2 portion 17322 in the second direction D2 may be equal to the length W_BS_17321 of the lower surface BS_17322 of the second-2 portion 17322 in the second direction D2. It shows a case like length W_BS_17322 in direction D2.

In addition, the length W_US_17331 of the upper surface US_17331 of the third-1 portion 17331 in the second direction D2 may be greater than the length W_BS_17331 of the lower surface BS_17331 of the third-1 portion 17331 in the second direction D2, the length W_BS_17331 of the lower surface BS_17331 of the third-1 portion 17331 in the second direction D2 may be equal to the length W_US_17332 of the upper surface US_17332 of the third-2 portion 17332 in the second direction D2, and the length W_US_17332 of the upper surface US_17332 of the third-2 portion 17332 in the second direction D2 may be equal to the length W_BS_17332 of the lower surface BS_17332 of the third-2 portion 17332 in the second direction D2.

In FIG. 23, the length W_US_17321 of the upper surface US_17321 of the second-1 portion 17321 in the second direction D2 may be equal to the length W_BS_17321 of the lower surface BS_17321 of the second-1 portion 17321 in the second direction D2, the length W_BS_17321 of the lower surface BS_17321 of the second-1 portion 17321 in the second direction D2 may be equal to the length W_US_17322 of the upper surface US_17322 of the second-2 portion 17322 in the second direction D2, and the length W_US_17322 of the upper surface US_17322 of the second-2 portion 17322 in the second direction D2 may be greater than the length W_BS_17322 of the lower surface BS_17322 of the second-2 portion 17322 in the second direction D2.

In addition, the length W_US_17331 of the upper surface US_17331 of the third-1 portion 17331 in the second direction D2 may be equal to the length W_BS_17331 of the lower surface BS_17331 of the third-1 portion 17331 in the second direction D2, the length W_BS_17331 of the lower surface BS_17331 of the third-1 portion 17331 in the second direction D2 may be equal to the length W_US_17332 of the upper surface US_17332 of the third-2 portion 17332 in the second direction D2, and the length W_US_17332 of the upper surface US_17332 of the third-2 portion 17332 in the second direction D2 may be greater than the length W_US_17332 of the lower surface BS_17332 of the third-2 portion 17332 in the second direction D2.

The description of the second portion and the third portion of the drain electrode 175 is the same as the description of the second portion 1732 and the third portion 1733 of the source electrode 173, so a repeated description is omitted.

Next, a method for manufacturing a semiconductor device according to an implementation will be described with reference to FIGS. 24 to 32. In addition, FIGS. 1 to 4 described above may also be referred to.

FIGS. 24 to 32 are cross-sectional views showing a semiconductor device manufacturing method according to process sequence.

Referring to FIG. 24, a seed layer 115, a buffer layer 120, a channel layer 132, and a barrier layer 136 may be sequentially formed on a substrate 110. Additionally, a gate semiconductor material layer 152_L may be formed on the barrier layer 136.

For example, the seed layer 115, the buffer layer 120, the channel layer 132, the barrier layer 136, and the gate semiconductor material layer 152_L may be sequentially formed using an epitaxial growth method. The seed layer 115 may be first formed on the substrate 110, and the buffer layer 120 may be formed on the seed layer 115. The buffer layer 120 may include a super-lattice layer and a high-resistivity layer. The channel layer 132 may be formed on the buffer layer 120, the barrier layer 136 may be formed on the channel layer 132, and the gate semiconductor material layer 152_L may be formed on the barrier layer 136.

For example, an equipment for growing the seed layer 115, the buffer layer 120, the channel layer 132, the barrier layer 136, and the gate semiconductor material layer 152_L may be used metal organic chemical vapor deposition (MOCVD), hydride vapor phase epitaxy (HVPE), or molecular beam epitaxy (MBE).

The seed layer 115, the buffer layer 120, the channel layer 132, the barrier layer 136, and the gate semiconductor material layer 152_L may be made of the same-based semiconductor material. However, the material composition ratio of each layer may be different depending on the role of each layer and the performance required for the semiconductor device.

For example, the substrate 110 may include Si, the seed layer 115 may include AIN, and the super-lattice layer of the buffer layer 120 may have a structure in which layers made of AlGaN and layers made of GaN are repeatedly stacked. The high-resistance layer of the buffer layer 120 may include GaN, the channel layer 132 may include GaN, and the barrier layer 136 may include AlGaN. The channel layer 132 and the barrier layer 136 may or may not be doped with impurities. The gate semiconductor material layer 152_L may contain GaN and may be doped with impurities. The gate semiconductor material layer 152_L may be doped with p-type impurities, for example, magnesium (Mg).

Because the lattice structure of Si and the lattice structure of GaN are different, it may not be easy to grow the channel layer 132 made of GaN directly on the substrate 110 made of Si. Therefore, by first forming the seed layer 115, or the buffer layer 120, etc. on the substrate 110 and then forming the channel layer 132, the lattice structure of the channel layer 132 may be stably formed.

Next, a first photoresist pattern PR1 may be formed on the gate semiconductor material layer 152_L.

First, a photoresist composition may be coated on the gate semiconductor material layer 152_L to form a photoresist film. For example, the photoresist film can be formed by applying a photoresist composition onto the gate semiconductor material layer 152_L using spin coating, spray coating, dip coating, knife edge coating methods, or printing methods such as inkjet printing or screen printing, and then drying the applied photoresist composition.

A first photoresist pattern PR1 may be formed by selectively exposing the photoresist film and using a developer to dissolve and remove the photoresist film corresponding to the unexposed or exposed region. For example, the region exposed by the first photoresist pattern PR1 may be the region where the source electrode 173 and the drain electrode 175 will be formed later.

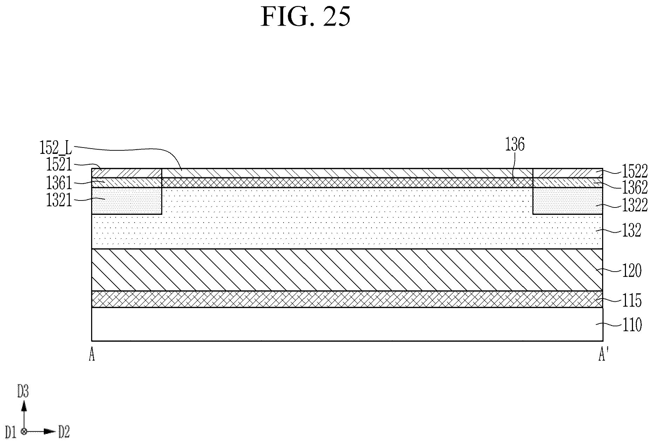

Referring to FIG. 25, a part of the gate semiconductor material layer 152_L exposed by the first photoresist pattern PR1 may be ion-doped.

For example, the ion-doping may use the ion-implantation (IIP) method. By controlling the power of the ion-implantation, the depth at which the ions are doped may be controlled. The ions may be doped up to the gate semiconductor material layer 152_L, the barrier layer 136, and the channel layer 132, and for example, the barrier layer 136 may be doped with the largest number of ions. In this case, since the ion-doping may be performed on the surface of the gate semiconductor material layer 152_L, the power of ion-implantation may be, for example, 30 eV to 80 eV.

In the region where the source electrode 173 is to be formed, a first gate semiconductor material layer doping region 1521 may be formed in the gate semiconductor material layer 152_L, a first barrier layer doping region 1361 may be formed in the barrier layer 136, and a first channel layer doping region 1321 may be formed in the channel layer 132.

Additionally, in the region where the drain electrode 175 is to be formed, a second gate semiconductor material layer doping region 1522 may be formed in the gate semiconductor material layer 152_L, a second barrier layer doping region 1362 may be formed in the barrier layer 136, and a second channel layer doping region 1322 may be formed in the channel layer 132.

After ion-doping, the first photoresist pattern PR1 may be removed, and the ion-doped first barrier layer doping region 1361, first channel layer doping region 1321, second barrier layer doping region 1362, and second channel layer doping region 1322 may be annealed at high temperature. For example, the annealing temperature may be greater than or equal to 1100 °C, for example greater than or equal to 1200 °C, greater than or equal to 1300 °C, greater than or equal to 1400 °C, greater than or equal to 1500 °C, greater than or equal to 1600 °C, greater than or equal to 1700 °C, greater than or equal to 1800 °C, or greater than or equal to 1900 °C, and less than or equal to 2000 °C, for example less than or equal to 1900 °C, less than or equal to 1800 °C, less than or equal to 1700 °C, less than or equal to 1600 °C, less than or equal to 1500 °C, less than or equal to 1400 °C, less than or equal to 1300 °C, or less than or equal to 1200 °C, for example 1100 °C to 2000 °C.

In some implementations, after forming the first barrier layer doping region 1361, the first gate semiconductor material layer doping region 1521 and the second gate semiconductor material layer doping region 1522 may be etched and removed using the first photoresist pattern PR1, thereby exposing the first barrier layer doping region 1361 and the second barrier layer doping region 1362.

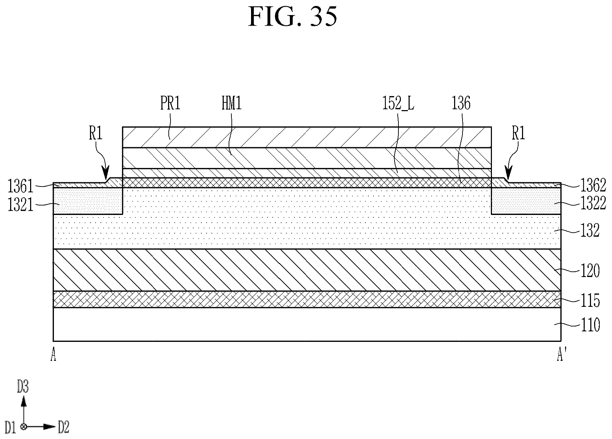

At this time, a part of the surface of the first barrier layer doping region 1361 and the second barrier layer doping region 1362 may be etched, so that a first recess R1 of FIG. 35 may be formed on the surface of the first barrier layer doping region 1361 and the second barrier layer doping region 1362. By this, the side SW_1732 of the second portion 1732 of the source electrode 173 in the second direction D2 may have a slope. Additionally, the side of the second portion of the drain electrode 175 in the second direction D2 may have a slope. In this case, the contact area of the source electrode 173 and the first barrier layer doping region 1361 may be increased, the contact area of the drain electrode 175 and the second barrier layer doping region 1362 may be increased, and the electric field concentration may be alleviated.

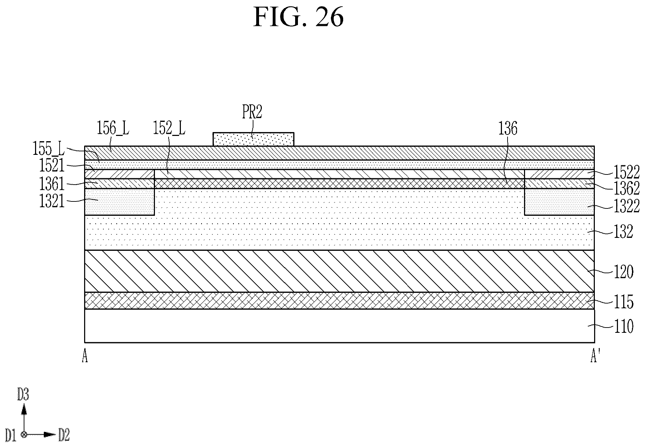

Referring to FIG. 26, a gate electrode material layer 155_L may be formed on a gate semiconductor material layer 152_L. In other words, the gate semiconductor material layer 152_L may be located between the barrier layer 136 and the gate electrode material layer 155_L.

For example, the gate electrode material layer 155_L may be formed using a deposition process. In some examples, the gate electrode material layer 155_L may be formed using, electron beam deposition, sputtering, physical vapor deposition (PVD), thermal chemical vapor deposition (thermal CVD), low-pressure chemical vapor deposition (LP-CVD), plasma-enhanced chemical vapor deposition (PE-CVD), or atomic layer deposition (ALD).

The first hard mask material layer 156_L may be formed on the gate electrode material layer 155_L.

For example, the first hard mask material layer 156_L may be a spin-on hardmask layer (SOH). The spin-on hard mask material layer may be formed on the gate electrode material layer 155_L through a spin coating process.

The first hard mask material layer 156_L may include silicon oxide, silicon nitride, silicon nitride, or a combination thereof.

Next, a second photoresist pattern PR2 may be formed on the first hard mask material layer 156_L.

First, a photoresist composition may be coated on the hard mask material layer 156_L to form a photoresist film. For example, a photoresist film may be formed by applying a photoresist composition onto the first hard mask material layer 156_L using a spin coating, spray coating, dip coating, knife edge coating method, or a printing method such as inkjet printing or screen printing, and then drying the applied photoresist composition.

Next, the photoresist film may be selectively exposed. A second photoresist pattern PR2 may be formed by dissolving and removing the photoresist film corresponding to the unexposed or exposed region using a developer.

Referring to FIGS. 27 and 28, the first hard mask material layer 156_L and the gate electrode material layer 155_L may be etched using the second photoresist pattern PR2 to form the second hard mask layer 156 and the gate electrode layer 155.

For example, the etching of the first hard mask material layer 156_L and the gate electrode material layer 155_L may be performed by dry etching using the first etching gas. The first etching gas may include fluoride gas, and the fluoride gas may include, for example, CHF₃, CF₄, or a mixed gas thereof.

At this time, the etching of the first hard mask material layer 156_L and the gate electrode material layer 155_L may be performed sequentially. Alternatively, the first hard mask material layer 156_L may be etched first, and then the gate electrode material layer 155_L may be etched. In this case, the etching of the first hard mask material layer 156_L and the gate electrode material layer 155_L may be performed using the same first etching gas.

In this way, since the gate electrode layer 155 is formed using the second photoresist pattern PR2, and the gate semiconductor layer 152 may be formed using the second hard mask layer 156 as described below, the gate electrode layer 155 may be etched with the first etching gas, and the gate semiconductor layer 152 may be etched with the second etching gas, so the degree of freedom for selecting the etching materials of the gate electrode layer 155 and the gate semiconductor layer 152 increases.

Referring to FIG. 29, the gate semiconductor material layer 152_L may be etched using the second hard mask layer 156 to form the gate semiconductor layer 152.

For example, the gate semiconductor material layer 152_L may be patterned using the second hard mask layer 156. Therefore, the gate semiconductor layer 152 may have a similar pattern to the gate electrode layer 155. In other words, the gate semiconductor layer 152 and the gate electrode layer 155 may be self-aligned, which enables easy and excellent alignment between the gate electrode layer 155 and the gate semiconductor layer 152. Since the loss of the second hard mask layer 156 may be less than that of the second photoresist pattern PR2, the pattern of the gate semiconductor layer 152 may be precise.

In some implementations, at this time, a part of the surface of the first barrier layer doping region 1361 and the second barrier layer doping region 1362 may be etched to form a first recess R1 of FIG. 35 on the surface of the first barrier layer doping region 1361 and the second barrier layer doping region 1362. By this, the side SW_1732 of the second portion 1732 of the source electrode 173 in the second direction D2 may have a slope. Additionally, the side of the second portion of the drain electrode 175 in the second direction D2 may have a slope. In this case, the contact area of the source electrode 173 and the first barrier layer doping region 1361 may be increased, the contact area of the drain electrode 175 and the second barrier layer doping region 1362 may be increased, and the electric field concentration may be alleviated.

For example, the etching of the gate semiconductor material layer 152_L may be performed by dry etching using a second etching gas. The second etching gas may be different from the first etching gas and may include chloride gas, for example, the chloride gas may include Cl₂, BCl₃, or a mixed gas thereof.

In order to minimize damage to the barrier layer 136 in the process of etching the gate semiconductor material layer 152_L, a selective etching process condition that provides a difference in the etch-rate of the gate semiconductor material layer 152_L and the barrier layer 136 may be required. For example, the barrier layer 136 made of AlGaN may be hardly etched, while the gate semiconductor material layer 152_L made of p-GaN may be etched well. At this time, a surface oxidation etching method may be used by adding oxygen O₂ to etching gas. Accordingly, if the barrier layer 136 is not damaged and has a predetermined thickness, the channel layer 132 may have a high current density.

At this time, depending on the etch condition during the etching of the gate semiconductor layer 152, the second hard mask layer 156 may have a shape in which the corners formed by the upper surface US_156 and the side surface SW_156 of the second hard mask layer 156 may be rounded as the second hard mask layer 156 may be partially etched.

In some implementations, a treatment process may be performed prior to etching the gate electrode layer 155 and the gate semiconductor layer 152, or after etching the gate electrode layer 155 and the gate semiconductor layer 152 to reduce damage to the barrier layer 136 due to byproduct removal and dry etching. For example, by-product removal may be accomplished through an ashing or strip process. The ashing process and strip process may be performed sequentially. For example, the ashing process may be performed first to remove the oxygen O₂ plasma treatment process or the ozone O₃ treatment process, and then the strip process may be performed. Apart from the ashing process or strip process, dry and wet treatment processes may be performed. For example, the treatment process may include a dry-cleaning process using, for example, N₂O plasma, N₂ plasma, NH₃ plasma, or O₂ plasma, or a wet cleaning process using diluted HF (DHF), BOE, or ammonia water (NH₄OH). In this process, the second photoresist pattern PR2 may be removed together, and the second hard mask layer 156 remaining on the gate electrode layer 155 may also be removed.

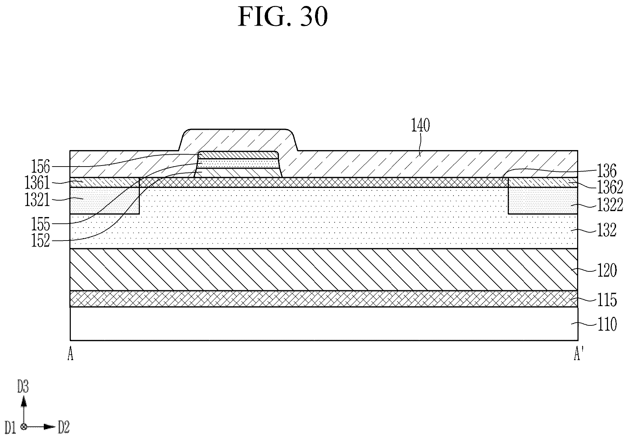

Referring to FIG. 30, a first protective layer 140 may be formed on the barrier layer 136, the first barrier layer doping region 1361, the second barrier layer doping region 1362, the gate semiconductor layer 152, and the gate electrode layer 155. The first protective layer 140 may be formed using a deposition process. The first protective layer 140 may include an insulating material. For example, the first protective layer 140 may include a material such as SiO₂, SiN, SiON, or Al₂O₃. The first protective layer 140 is shown as a single layer but may be formed of multiple layers in some cases. At this time, different materials may be sequentially deposited to form the first protective layer 140. Alternatively, by using the same material and varying the deposition conditions, a first protective layer 140 composed of multiple layers with different characteristics may be formed. Particularly, a part of the first protective layer 140 adjacent to the barrier layer 136 may be made of an insulating material of much better quality than the other portions. This is to prevent electrons forming a channel within the channel layer 132 located below the barrier layer 136 from being trapped. A part of the first protective layer 140 in contact with the barrier layer 136 may be made of SiO₂.

In this way, by first forming the gate electrode layer 155 and the gate semiconductor layer 152, and then forming the barrier layer 136, the first barrier layer doping region 1361, the second barrier layer doping region 1362, the gate semiconductor layer 152, and the first protective layer 140 covering the gate electrode layer 155, the first protective layer 140 may cover the entire gate electrode layer 155. In this case, the alignment between the gate electrode layer 155 and the gate semiconductor layer 152 may be improved.

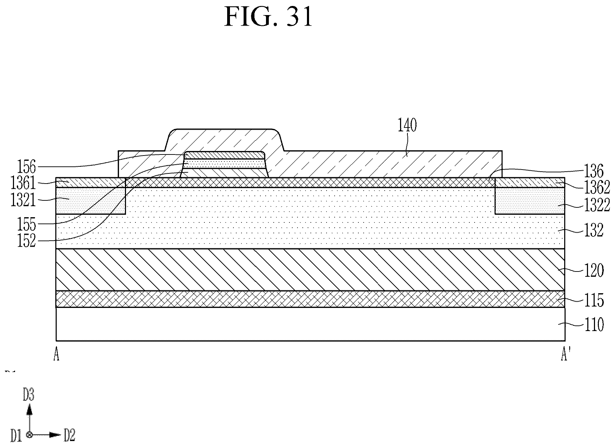

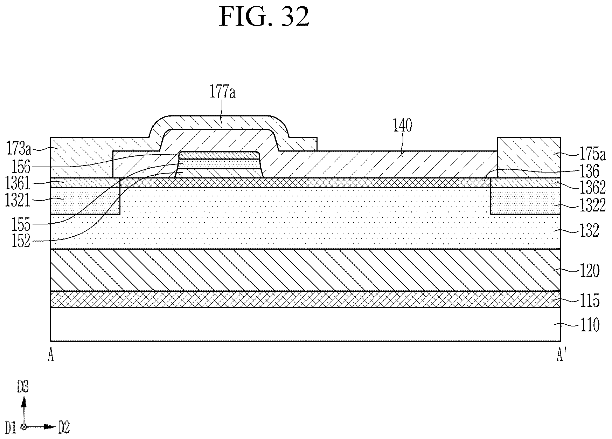

Referring to FIGS. 31 and 32, a first protective layer 140 may be patterned to form a trench, and a lower source electrode 173a and a lower drain electrode 175a may be formed within the trench.

For example, the trench may be formed in a region where the first barrier layer doping region 1361 and the first channel layer doping region 1321 may be formed, and a region where the second barrier layer doping region 1362 and the second channel layer doping region 1322 may be formed.

In some implementations, the process of forming the trench may involve patterning not only the first protective layer 140, but also parts of the first barrier layer doping region 1361 and the second barrier layer doping region 1362. Additionally, all of the first barrier layer doping region 1361 and the second barrier layer doping region 1362 and parts of the first channel layer doping region 1321 and the second channel layer doping region 1322 may be patterned together.

For example, when a part of the first protective layer 140 may be etched to expose the first channel layer doping region 1321 and the second channel layer doping region 1322, a part of the surface of the first channel layer doping region 1321 and the second channel layer doping region 1322 may be etched, so that a second recess R2 of FIG. 40 may be formed on the surface of the first channel layer doping region 1321 and the second channel layer doping region 1322. Accordingly, the side SW_1733 of the third portion 1733 of the source electrode 173 in the second direction D2 may have a slope. Additionally, the side of the third portion of the drain electrode 175 in the second direction D2 may have a slope. In this case, the contact area between the source electrode 173 and the first channel layer doping region 1321 may be increased, the contact area between the drain electrode 175 and the second channel layer doping region 1322 may be increased, and the electric field concentration may be alleviated.

Additionally, the first field dispersion layer 177a may be formed together in the process of forming the lower source electrode 173a and the lower drain electrode 175a.

Again, referring to FIGS. 1 to 4, a second protective layer 150 may be formed on the first protective layer 140, the lower source electrode 173a, the lower drain electrode 175a, and the first field dispersion layer 177a, the second protective layer 150 may be patterned to form a trench, and the middle source electrode 173b and the middle drain electrode 175b may be formed within the trench, and the second field dispersion layer 177b may be formed together.

In addition, a third protective layer 160 may be formed on the second protective layer 150, the middle source electrode 173b, the middle drain electrode 175b, and the second field dispersion layer 177b, the third protective layer 160 may be patterned to form a trench, and the upper source electrode 173c and the upper drain electrode 175c may be formed within the trench, and the third field dispersion layer 177c may be formed together.

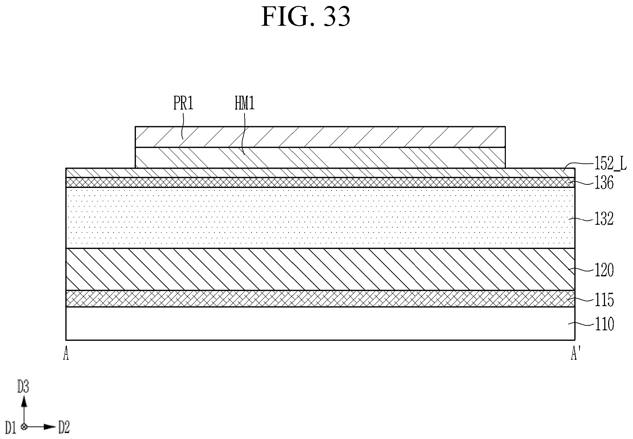

FIGS. 33 to 40 are cross-sectional views showing a method for manufacturing a semiconductor device according to another implementation in order of processes. Since the implementations shown in FIGS. 33 and 40 have many of the same parts as the implementations shown in FIGS. 24 and 32, the description thereof will be omitted and the differences will be mainly explained. Additionally, the same reference numerals are used for the same components as those in the previous implementation.

Referring to FIG. 33, a seed layer 115, a buffer layer 120, a channel layer 132, and a barrier layer 136 may be sequentially formed on a substrate 110.

Additionally, a gate semiconductor material layer 152_L may be formed on the barrier layer 136, and a first hard mask layer HM1 may be formed on the gate electrode material layer 155_L.

The first hard mask layer HM1 may be formed by first forming a hard mask material layer on the gate electrode material layer 155_L, forming the first photoresist pattern PR1 on the hard mask material layer, and then etching the hard mask material layer using the first photoresist pattern PR1.

For example, the hard mask material layer may be a spin-on hardmask layer (SOH). The spin-on hard mask material layer may be formed on the gate electrode material layer 155_L through a spin coating process.

The hard mask material layer may include silicon oxide, silicon nitride, silicon nitride, or a combination thereof.

For example, the first photoresist pattern PR1 and the region exposed by the first photoresist pattern PR1 may be the region where the source electrode 173 and the drain electrode 175 will be formed later.

Referring to FIG. 34, a part of the gate semiconductor material layer 152_L may be removed by etching using the first photoresist pattern PR1 or the first hard mask layer HM1, thereby exposing the barrier layer 136.

At this time, a part of the surface of barrier layer 136 may be etched to form a first recess R1 on the surface of barrier layer 136. By this, the side SW_1732 of the second portion 1732 of the source electrode 173 in the second direction D2 may have a slope. Additionally, the side of the second portion of the drain electrode 175 in the second direction D2 may have a slope. In this case, the contact area of the source electrode 173 and the first barrier layer doping region 1361 may be increased, the contact area of the drain electrode 175 and the second barrier layer doping region 1362 may be increased, and the electric field concentration may be alleviated.

Referring to FIG. 35, a part of the barrier layer 136 exposed by the first photoresist pattern PR1 or the first hard mask layer HM1 may be ion-doped.

For example, the ion-doping may use the ion-implantation (IIP) method. By controlling the power of the ion-implantation, the depth at which the ions are doped may be controlled. The ions may be doped up to the barrier layer 136 and the channel layer 132, and the largest number of ions may be doped in barrier layer 136. In this case, since the ion-doping is performed directly on the surface of barrier layer 136, the power of ion-implantation may be, for example, 10 eV to 30 eV.

In the region where the source electrode 173 is formed, a first barrier layer doping region 1361 may be formed in the barrier layer 136, and a first channel layer doping region 1321 may be formed in the channel layer 132.

Additionally, in the region where the drain electrode 175 is formed, a second barrier layer doping region 1362 may be formed in the barrier layer 136, and a second channel layer doping region 1322 may be formed in the channel layer 132.

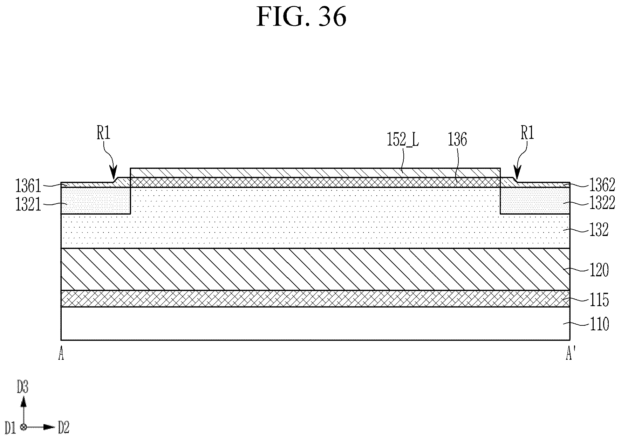

Referring to FIG. 36, after ion-doping, the first photoresist pattern PR1 and the first hard mask layer HM1 may be removed, and the ion-doped first barrier layer doping region 1361, first channel layer doping region 1321, second barrier layer doping region 1362, and second channel layer doping region 1322 may be annealed at high temperature. For example, the annealing temperature may be greater than or equal to 1100 °C, for example greater than or equal to 1200 °C, greater than or equal to 1300 °C, greater than or equal to 1400 °C, greater than or equal to 1500 °C, greater than or equal to 1600 °C, greater than or equal to 1700 °C, greater than or equal to 1800 °C, or greater than or equal to 1900 °C, and less than or equal to 2000 °C, for example less than or equal to 1900 °C, less than or equal to 1800 °C, less than or equal to 1700 °C, less than or equal to 1600 °C, less than or equal to 1500 °C, less than or equal to 1400 °C, less than or equal to 1300 °C, or less than or equal to 1200 °C.

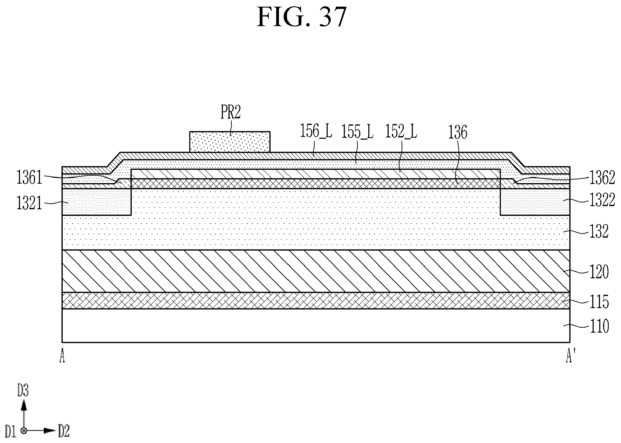

Referring to FIG. 37, a gate electrode material layer 155_L may be formed on a gate semiconductor material layer 152_L.

Additionally, a second hard mask material layer 156_L may be formed on the gate electrode material layer 155_L.

Next, a second photoresist pattern PR2 may be formed on the second hard mask material layer 156_L.

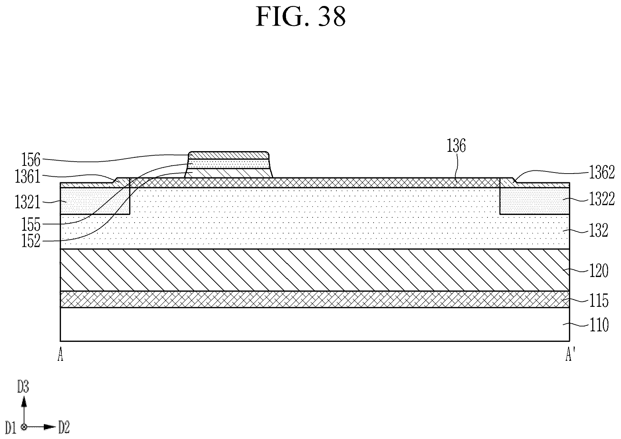

Referring to FIG. 38, the second hard mask material layer 156_L and the gate electrode material layer 155_L may be etched using the second photoresist pattern PR2 to form the second hard mask layer 156 and the gate electrode layer 155.

The gate semiconductor material layer 152_L may be etched using the second hard mask layer 156 to form the gate semiconductor layer 152.

In some implementations, before etching the gate electrode layer 155 and before etching the gate semiconductor layer 152, or after etching the gate electrode layer 155 and the gate semiconductor layer 152, a treatment process may be performed to reduce damage to the barrier layer 136 due to byproduct removal and dry etching, during which the second photoresist pattern PR2 may be removed together, and the second hard mask layer 156 remaining on the gate electrode layer 155 may be removed.

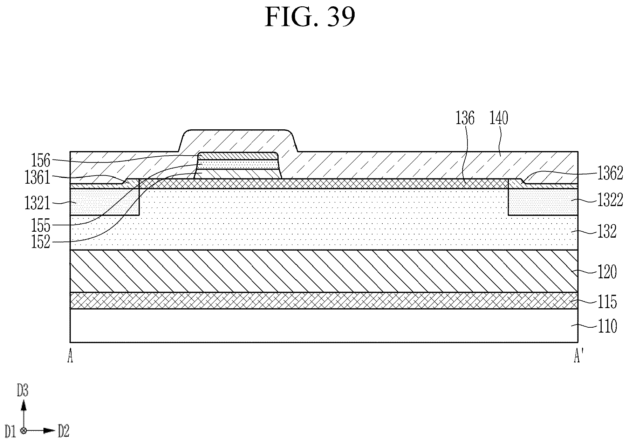

Referring to FIG. 39, a first protective layer 140 may be formed on the barrier layer 136, the first barrier layer doping region 1361, the second barrier layer doping region 1362, the gate semiconductor layer 152, and the gate electrode layer 155.

Referring to FIG. 40, a trench may be formed by patterning the first protective layer 140.

For example, a trench may be formed in a region where the first barrier layer doping region 1361 and the first channel layer doping region 1321 may be formed, and a region where the second barrier layer doping region 1362 and the second channel layer doping region 1322 may be formed.

In some implementations, the process of forming the trench may involve patterning not only the first protective layer 140, but also parts of the first barrier layer doping region 1361 and the second barrier layer doping region 1362. Additionally, all of the first barrier layer doping region 1361 and the second barrier layer doping region 1362 and a part of the first channel layer doping region 1321 and the second channel layer doping region 1322 may be patterned together.

For example, when a part of the first protective layer 140 is etched to expose the first channel layer doping region 1321 and the second channel layer doping region 1322, a part of the surface of the first channel layer doping region 1321 and the second channel layer doping region 1322 may be etched, so that a second recess R2 may be formed on the surface of the first channel layer doping region 1321 and the second channel layer doping region 1322. Accordingly, the side SW_1733 of the third portion 1733 of the source electrode 173 in the second direction D2 may have a slope. Additionally, the side of the third portion of the drain electrode 175 in the second direction D2 may have a slope. In this case, the contact area between the source electrode 173 and the first channel layer doping region 1321 may be increased, the contact area between the drain electrode 175 and the second channel layer doping region 1322 may be increased, and the electric field concentration may be alleviated.

Again, referring to FIGS. 1 to 4, the lower source electrode 173a and the lower drain electrode 175a may be formed within the trench.

In the process of forming the lower source electrode 173a and the lower drain electrode 175a, the first field dispersion layer 177a may be formed together.

Next, a second protective layer 150 may be formed on the first protective layer 140, the lower source electrode 173a, the lower drain electrode 175a, and the first field dispersion layer 177a, and the second protective layer 150 may be patterned to form a trench, and a middle source electrode 173b and a middle drain electrode 175b may be formed within the trench, and the second field dispersion layer 177b may be formed together.

In addition, a third protective layer 160 may be formed on the second protective layer 150, the middle source electrode 173b, the middle drain electrode 175b, and the second field dispersion layer 177b, the third protective layer 160 may be patterned to form a trench, and the upper source electrode 173c and the upper drain electrode 175c may be formed within the trench, and the third field dispersion layer 177c may be formed together.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device, comprising:
a channel layer (132);
a barrier layer (136) on the channel layer (132);
a gate electrode layer (155) on the barrier layer (136) and extending in a first direction (D1) parallel to an upper surface (US_136) of the barrier layer (136);
a gate semiconductor layer (152) between the barrier layer (136) and the gate electrode layer (155);
a source electrode (173) and a drain electrode (175) that are connected to the channel layer (132) and that are spaced apart from the gate electrode layer (155) in a second direction (D2), the second direction (D2) being parallel to the upper surface (US_136) of the barrier layer (136) and being different from the first direction (D1); and
a first barrier layer doping region (1361) within the barrier layer (136) and connected to the source electrode (173),
wherein, in a cross-section in the second direction (D2) and in a third direction (D3) that is perpendicular to the upper surface (US_136) of the barrier layer (136), a length (W_US_155) of an upper surface (US_155) of the gate electrode layer (155) in the second direction (D2) is less than a length (W_BS_155) of a lower surface (BS_155) of the gate electrode layer (155) in the second direction (D2).

2. The semiconductor device of claim 1, wherein the semiconductor device comprises a first channel layer doping region (1321) within the channel layer (132) and below the source electrode (173).

3. The semiconductor device of claim 2, wherein a length (W_ 173) of the source electrode (173) in the second direction (D2) is greater than or equal to a length (W_ 1361) of the first barrier layer doping region (1361) in the second direction (D2), and
wherein the length (W_ 173) of the source electrode (173) in the second direction (D2) is greater than or equal to a length (W_ 1321)of the first channel layer doping region (1321) in the second direction (D2).

4. The semiconductor device of claim 2, wherein a length (W_ 173) of the source electrode (173) in the second direction (D2) is less than or equal to a length (W_ 1361) of the first barrier layer doping region (1361) in the second direction (D2), and
wherein the length (W_ 173) of the source electrode (173) in the second direction (D2) is less than or equal to a length (W_ 1321) of the first channel layer doping region (1321) in the second direction (D2).

5. The semiconductor device of any one of claims 2 to 4, wherein the source electrode (173) comprises:
a first portion (1731) on the first barrier layer doping region (1361); and
a second portion (1732) that protrudes from the first portion (1731) toward the first barrier layer doping region (1361) and that is within the first barrier layer doping region (1361), and
wherein the second portion (1732) has a sloped side that extends at an angle relative to the second direction (D2).

6. The semiconductor device of claim 5, wherein the second portion (1732) extends downward in the third direction (D3), is offset from the first barrier layer doping region (1361), and is spaced apart from an upper surface (US_1361) of the first channel layer doping region (1321), and
wherein at least a portion of the first barrier layer doping region (1361) is between the second portion (1732) and the first channel layer doping region (1321).

7. The semiconductor device of claim 5, wherein the second portion (1732) of the source electrode (173) extends downward in the third direction (D3), extends into the first barrier layer doping region (1361), and is connected to the first channel layer doping region (1321).

8. The semiconductor device of any one of claims 5 to 7, wherein the source electrode (173) comprises a third portion (1733) that protrudes from the second portion (1732) toward the first channel layer doping region (1321) and that is within the first channel layer doping region (1321), and
wherein the third portion (1733) has a sloped side that extends at an angle relative to the second direction (D2).

9. The semiconductor device of claim 8, wherein the second portion (1732) of the source electrode (173) extends downward in the third direction (D3), extends into the first barrier layer doping region (1361), and is connected to the first channel layer doping region (1321),
wherin the third portion (1733) of the source electrode (173) extends downward in the third direction (D3), is offset from the first channel layer doping region (1321), and is spaced apart from a lower surface (BS_1321) of the first channel layer doping region (1321), and
wherein at least a portion of the first channel layer doping region (1321) is between the third portion (1733) and a lower surface (BS_1321) of the first channel layer doping region (1321).

10. The semiconductor device of claim 8 or 9, wherein a length (W_BS_1731) of a lower surface (BS_1731) of the first portion (1731) of the source electrode (173) in the second direction (D2) is greater than or equal to a length (W_US_1732) of an upper surface (US_1732) of the second portion (1732) of the source electrode (173) in the second direction (D2),
wherein the length (W_US_1732) of the upper surface (US_1732) of the second portion (1732) in the second direction (D2) is greater than a length (W_BS_1732) of a lower surface (BS_1732) of the second portion (1732) in the second direction (D2),
wherein the length (W_BS_1732) of the lower surface (BS_1732) of the second portion (1732) in the second direction (D2) is greater than or equal to a length (W_US_1733) of an upper surface (US_1733) of the third portion (1733) of the source electrode (173) in the second direction (D2), and
wherein the length (W_US_1733) of an upper surface (US_1733) of the third portion (1733) in the second direction (D2) is greater than a length (W_BS_1733) of a lower surface (BS_1733) of the third portion (1733) in the second direction (D2).

11. The semiconductor device of any one of claims 8 to 10, wherein the second portion (1732) of the source electrode (173) comprises (i) a second-1 portion (17321) below the first portion (1731) in the third direction (D3) and (ii) a second-2 portion (17322) below the second-1 portion (17321) in the third direction (D3) and between the third portion (1733) and the second-1 portion (17321),
wherein a length (W_US_17321) of an upper surface (US_17321) of the second-1 portion (17321) in the second direction (D2) is greater than or equal to a length (W_BS_17321) of a lower surface (BS_17321) of the second-1 portion (17321) in the second direction (D2),
wherein a length (W_BS_17321) of a lower surface (BS_17321) of the second-1 portion (17321) in the second direction (D2) is greater than or equal to a length (W_US_17322) of an upper surface (US_17322) of the second-2 portion (17322) in the second direction (D2),
wherein a length (W_US_17322) of an upper surface (US_17322) of the second-2 portion (17322) in the second direction (D2) is greater than or equal to a length (W_BS_17322) of a lower surface (BS_17322) of the second-2 portion (17322) in the second direction (D2), and
wherein a length (W_US_17321) of an upper surface (US_17321) of the second-1 portion (17321) in the second direction (D2) is greater than a length (W_BS_17322) of a lower surface (BS_17322) of the second-2 portion (17322) in the second direction (D2).

12. The semiconductor device of any one of claims 8 to 11, wherein the third portion (1733) of the source electrode (173) further has (i) a third-1 portion (17331) below the second portion (1732) in the third direction (D3) and (ii) a third-2 portion (17332) below the third-1 portion (17331) in the third direction (D3),
wherein a length (W_BS_1732) of a lower surface (BS_1732) of the second portion (1732) of the source electrode (173) in the second direction (D2) is greater than or equal to a length (W_US_17331) of an upper surface (US_17331) of the third-1 portion (17331) in the second direction (D2),
wherein a length (W_US_17331) of an upper surface (US_17331) of the third-1 portion (17331) in the second direction (D2) is greater than or equal to a length (W_BS_17331) of a lower surface (BS_17331) of the third-1 portion (17331) in the second direction (D2),
wherein a length (W_US_17332) of an upper surface (US_17332) of the third-2 portion (17332) in the second direction (D2) is greater than or equal to a length (W_BS_17332) of a lower surface (BS_17332) of the third-2 portion (17332) in the second direction (D2), and
wherein a length (W_US_17331) of the upper surface (US_17331) of the third-1 portion (17331) in the second direction (D2) is greater than a length (W_BS_17332) of the lower surface (BS_17332) of the third-2 portion (17332) in the second direction (D2).

13. The semiconductor device of any one of claims 2 to 12, wherein the semiconductor device comprises:
a second barrier layer doping region (1362) within the barrier layer (136) and connected to the drain electrode (175); and
a second channel layer doping region (1322) within the channel layer (132) and below the drain electrode (175).

14. The semiconductor device of any one of claims 1 to 13, wherein an angle defined by a lower surface (BS_155) of the gate electrode layer (155) and a side surface (SW_155) of the gate electrode layer (155) in the second direction (D2) is greater than an angle defined by a lower surface (BS_152) of the gate semiconductor layer (152) and a side surface (SW_152) of the gate semiconductor layer (152) in the second direction (D2).

15. The semiconductor device of any one of claims 1 to 14, wherein the semiconductor device comprises a hard mask layer (156) on the gate electrode layer (155), and
wherein a corner formed by an upper surface (US_156) of the hard mask layer (156) and a side surface (SW_156) of the hard mask layer (156) in the second direction (D2) has a rounded shape.
